(19) Europäisches Patentamt
European Patent Office
Office européen des brevets

(11) **EP 4 753 178 A1**

(12) **EUROPEAN PATENT APPLICATION**
published in accordance with Art. 153(4) EPC

(43) Date of publication:
**03.06.2026 Bulletin 2026/23**

(21) Application number: **23950056.4**

(22) Date of filing: **29.08.2023**

(51) International Patent Classification (IPC):
**H04L 1/00** (2006.01)        **H03M 13/11** (2006.01)

(52) Cooperative Patent Classification (CPC):
**H03M 13/11; H04L 1/00**

(86) International application number:
**PCT/CN2023/115376**

(87) International publication number:
**WO 2025/043462 (06.03.2025 Gazette 2025/10)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **HUAWEI TECHNOLOGIES CO., LTD.
Shenzhen 518129 (CN)**

(72) Inventors:
• **LIU, Ke
Shenzhen, Guangdong 518129 (CN)**

• **TONG, Jiajie
Shenzhen, Guangdong 518129 (CN)**
• **ZHANG, Huazi
Shenzhen, Guangdong 518129 (CN)**
• **QIN, Kangjian
Shenzhen, Guangdong 518129 (CN)**
• **WANG, Jun
Shenzhen, Guangdong 518129 (CN)**

(74) Representative: **Goddar, Heinz J.
Boehmert & Boehmert
Anwaltspartnerschaft mbB
Pettenkoferstrasse 22
80336 München (DE)**

(54) **LDPC CODE-BASED COMMUNICATION METHOD AND COMMUNICATION APPARATUS**

(57)    An LDPC code-based communication method and a communication apparatus are provided. There is a nested relationship between base graphs, so that a base graph of a small scale can be derived based on a base graph of a large scale. The communication apparatus may store a base graph of a largest scale. When another base graph needs to be used for encoding or decoding, the communication apparatus may derive a required base graph based on the base graph of the largest scale. In this way, content that needs to be stored by the communication apparatus can be reduced.

FIG. 6

## Description

### TECHNICAL FIELD

This application relates to the coding field, and more specifically, to an LDPC code-based communication method and a communication apparatus.

### BACKGROUND

In the field of channel coding, a low-density parity check (low-density parity check, LDPC) code is one of most mature and widely applied channel coding schemes. A current standard protocol specifies that two base graphs (base graph, BG), namely a BG 1 and a BG 2, are stored, and specifies that the BG 2 is used when an information length is less than or equal to 292, or an information length is less than or equal to 3840 and a code rate is less than or equal to 2/3, or a code rate is less than or equal to 0.25, and the BG 1 is used in other cases. In the future, a quantity of base graphs may increase, and content stored in a device may become very complex.

### SUMMARY

This application provides an LDPC code-based communication method and a communication apparatus, to help reduce content stored in a device.

According to a first aspect, an LDPC code-based communication method is provided. The method may be performed by a transmit end device. Unless otherwise specified, a "transmit end device" may be the transmit end device, or may be an apparatus that can support the transmit end device in implementing the function. For ease of description, the transmit end device is used for description in the following. The transmit end device may be a terminal device or a network device.

The method includes: obtaining an information bit sequence; encoding the information bit sequence based on a first base graph, to obtain an LDPC codeword sequence, where the first base graph includes a first column set and check columns of a second base graph, the first column set is obtained based on at least one of a plurality of column groups included in information columns of the second base graph, column numbers included in any two of the plurality of column groups are different, and the second base graph includes the check columns and the information columns; and outputting the LDPC codeword sequence.

In the foregoing method, the first base graph includes the first column set and the check columns of the second base graph, and the first column set may be obtained based on at least one of the plurality of column groups included in the information columns of the second base graph. In other words, the first base graph may be obtained based on the second base graph. In this way, the transmit end device may not store the first base graph. When the first base graph needs to be used for encoding, the transmit end device may derive the required first base graph based on the second base graph, so that content that needs to be stored by the transmit end device is reduced. In addition, the first column set is obtained based on at least one of the plurality of column groups included in the information columns of the second base graph, so that a connection edge density of the first base graph can be flexibly controlled, to help ensure an optimal connection edge density of the first base graph.

With reference to the first aspect, in some implementations, the first column set includes some information columns of the second base graph.

In the foregoing method, the first column set includes some information columns of the second base graph. In this way, a scale of the obtained first base graph is less than that of the second base graph. In other words, in the foregoing method, a base graph of a small scale can be derived from a base graph of a large scale. In this way, the transmit end device may store only a base graph of a largest scale, and when another base graph needs to be used, a required base graph is derived based on the base graph of the largest scale, so that content that needs to be stored by the transmit end device is reduced.

With reference to the first aspect or any one of the implementations of the first aspect, in some other implementations, the plurality of column groups include the information columns of the second base graph, and the first column set includes columns selected based on the plurality of column groups; or the plurality of column groups include non-punctured information columns of the second base graph, and the first column set includes columns selected based on the plurality of column groups and a punctured information column of the second base graph.

With reference to the first aspect or any one of the implementations of the first aspect, in some other implementations, a quantity of columns included in the plurality of column groups is 26, and a quantity of columns included in each of the plurality of column groups is 2; or a quantity of columns included in the plurality of column groups is 33 or 30, and a quantity of columns included in each of the plurality of column groups is 3; or a quantity of columns included in the plurality of column groups is 36 or 40, and a quantity of columns included in each of the plurality of column groups is 4.

With reference to the first aspect or any one of the implementations of the first aspect, in some other implementations, a quantity of punctured information columns included in the second base graph is 0, 1, or 2.

With reference to the first aspect or any one of the implementations of the first aspect, in some other implementations, the method further includes: determining, based on screening information, to perform LDPC encoding on the information bit sequence based on the first base graph, where the screening information includes at least one of the following information: an application scenario of the information bit sequence, a code length required for transmitting the information bit sequence, a code rate required for transmitting the information bit sequence, or a quantity of non-zero elements included in the first base graph.

Different base graphs have different dominant intervals. Base graph screening is performed according to the foregoing method, so that code lengths, code rates, and hardware utilization are good.

With reference to the first aspect or any one of the implementations of the first aspect, in some other implementations, the application scenario includes at least one of the following scenarios: a high-throughput scenario, a high-reliability scenario, a low-latency scenario, a high-reliability and low-latency scenario, or a low power consumption scenario.

With reference to the first aspect or any one of the implementations of the first aspect, in some other implementations, the screening information includes the application scenario, the screening information further includes at least one of the application scenario of the information bit sequence, the code length required for transmitting the information bit sequence, the code rate required for transmitting the information bit sequence, or the quantity of non-zero elements included in the first base graph, and determining, based on the screening information, to perform LDPC encoding on the information bit sequence based on the first base graph includes: when the application scenario is a predefined scenario, determining to perform LDPC encoding on the information bit sequence based on the first base graph corresponding to the application scenario; and/or when the application scenario is not a predefined scenario, determining, based on at least one of the code length required for transmitting the information bit sequence, the code rate required for transmitting the information bit sequence, or the quantity of non-zero elements included in the first base graph, to perform LDPC encoding on the information bit sequence based on the first base graph.

Based on the foregoing method, the base graph is preferentially selected based on the application scenario, so that requirements of each application scenario can be met, and requirements such as a high throughput, a low latency, and low power consumption can be met.

With reference to the first aspect or any one of the implementations of the first aspect, in some other implementations, the first column set includes an $i^{th}$ column to a $j^{th}$ column of each of the plurality of column groups, and j-i is an integer greater than 0 and less than k; or the first column set includes an $m^{th}$ column of each of the plurality of column groups, and m is an integer less than k, where k is a quantity of columns included in each of the plurality of column groups.

In the foregoing method, the first column set may be obtained by reserving an information column at a specific location in each of the plurality of column groups. This manner is easy to implement.

With reference to the first aspect or any one of the implementations of the first aspect, in some other implementations, the first column set includes all columns of each column group in a first set and some columns of each column group in a second set, and the first set and the second set do not overlap.

Optionally, the second set includes at most one column group.

In the foregoing method, the first column set may be obtained by reserving all columns of each column group in the first set and some columns of each column group in the second set, and not reserving columns in column groups other than the first set and the second set.

With reference to the first aspect or any one of the implementations of the first aspect, in some other implementations, the method further includes: determining the first base graph based on the second base graph, first information, and second information, where the first information indicates the first set, and the second information indicates some columns of each first column group in the second set.

In the foregoing method, the first base graph may be obtained based on the second base graph, the first information, and the second information. In this way, the transmit end device may not store the first base graph, and stored content is simple.

With reference to the first aspect or any one of the implementations of the first aspect, in some other implementations, the method further includes: determining the first base graph based on the second base graph and a first sequence, where the first sequence indicates columns that are in each of the plurality of column groups and that are used to form the first column set.

In the foregoing method, one sequence may indicate columns that are in each of the plurality of column groups and that are used to form the first column set. Compared with reserving an information column at a specific location in each of the plurality of column groups, the first column set can be obtained more flexibly in this implementation.

With reference to the first aspect or any one of the implementations of the first aspect, in some other implementations, a quantity of columns selected based on the plurality of column groups in the first column set is P, and the first sequence is obtained by extracting first P elements from a storage sequence.

In the foregoing method, different base graphs may be obtained based on sequences of different lengths that are captured from the storage sequence. For example, the first base graph may be obtained based on the first sequence whose length is P that is obtained by capturing first P elements from the storage sequence. An advantage of this implementation is that base graphs of different dominant intervals can be screened more precisely, and more applicable base graphs can be derived.

Optionally, some or all rows of the second base graph may include a plurality of row groups, the plurality of row groups and the plurality of column groups may form a plurality of grouping structures or grouping units, and a column weight of a column of a grouping unit included in the second base graph is not greater than 1. Specifically, the grouping units included in the second base graph may be classified into three types. A column weight of each column of a first-type grouping unit is 1, a column weight of at least one column of a second-type grouping unit is 1 and a column weight of a remaining column is 0, and a column weight of each column of a third-type grouping unit is 0. Because the column weight of each column in the first-type grouping unit, the second-type grouping unit, and the third-type grouping unit is not greater than 1, the receive end device may perform parallel decoding on a plurality of QC blocks on a codeword sequence corresponding to each grouping unit, and a case in which decoding cannot be performed does not occur. This helps improve decoding performance. In addition, only the second-type grouping unit causes a waste of some hardware resources. Therefore, hardware utilization can be improved.

When the second base graph includes the foregoing plurality of grouping units, the first column set is obtained by reserving an information column at a specific location in each of the plurality of column groups, so that a connection edge density of the first base graph can be flexibly controlled, to ensure that the connection edge density of the first base graph is optimal, and ensure that the second base graph and the first base graph have obvious dominant interval division.

When the second base graph includes the plurality of grouping units, the first column set is obtained by reserving all columns of each column group in some of the plurality of column groups and some columns of at most one column group, so that most grouping units of the second base graph can be reserved, to help improve hardware resource utilization.

With reference to the first aspect or any one of the implementations of the first aspect, in some other implementations, when there is a punctured information column in the second base graph, the information columns in the second base graph include a punctured information column and non-punctured information columns.

With reference to the first aspect or any one of the implementations of the first aspect, in some other implementations, a number of an information column in the first base graph is the same as a number of an information column in the second base graph, and encoding the information bit sequence based on the first base graph, to obtain the LDPC codeword sequence includes: performing shortening processing on an information column that is not included in the first base graph and that belongs to the second base graph.

With reference to the first aspect or any one of the implementations of the first aspect, in some other implementations, columns in the first base graph are sequentially numbered.

According to a second aspect, an LDPC code-based communication method is provided. The method may be performed by a receive end device. Unless otherwise specified, the "receive end device" may be the receive end device, or may be an apparatus that can support the receive end device in implementing the function. For ease of description, the receive end device is used for description in the following. The receive end device may be a terminal device or a network device.

The method includes: receiving an LDPC codeword sequence; and decoding the LDPC codeword sequence based on a first base graph, where the first base graph includes a first column set and check columns of a second base graph, the first column set is obtained based on at least one of a plurality of column groups included in information columns of the second base graph, column numbers included in any two of the plurality of column groups are different, and the second base graph includes the check columns and the information columns.

In the foregoing method, the first base graph includes the first column set and the check columns of the second base graph, and the first column set may be obtained based on at least one of the plurality of column groups included in the information columns of the second base graph. In other words, the first base graph may be obtained based on the second base graph. In this way, the receive end device may not store the first base graph. When the first base graph needs to be used for encoding, the receive end device may derive the required first base graph based on the second base graph, so that content that needs to be stored by the receive end device is reduced. In addition, the first column set is obtained based on at least one of the plurality of column groups included in the information columns of the second base graph, so that a connection edge density of the first base graph can be flexibly controlled, to help ensure an optimal connection edge density of the first base graph.

With reference to the second aspect, in some implementations, the method further includes: determining, based on screening information, to decode the LDPC codeword sequence based on the first base graph, where the screening information includes at least one of the following information: an application scenario of the information bit sequence, a code length required for transmitting the information bit sequence, a code rate required for transmitting the information bit sequence, or a quantity of non-zero elements included in the first base graph.

With reference to the second aspect or any one of the implementations of the second aspect, in some other implementations, the screening information includes the application scenario, the screening information further includes at least one of the application scenario of the information bit sequence, the code length required for transmitting the information bit sequence, the code rate required for transmitting the information bit sequence, or the quantity of non-zero elements included in the first base graph, and determining, based on screening information, to decode the LDPC codeword sequence based on the first base graph includes: when the application scenario is a predefined scenario, determining to decode the LDPC codeword sequence based on the first base graph corresponding to the application scenario; and/or when the application scenario is not a predefined scenario, determining, based on at least one of the code length required for transmitting the information bit sequence, the code rate required for transmitting the information bit sequence, or the quantity of non-zero elements included in the first base graph, to decode the LDPC codeword sequence based on the first base graph.

With reference to the second aspect or any one of the implementations of the second aspect, in some other implementations, the method further includes: determining the first base graph based on the second base graph, first information, and second information, where the first information indicates the first set, and the second information indicates some columns of each first column group in the second set.

With reference to the second aspect or any one of the implementations of the second aspect, in some other implementations, the method further includes: determining the first base graph based on the second base graph and a first sequence, where the first sequence indicates columns that are in each of the plurality of column groups and that are used to form the first column set.

With reference to the second aspect or any one of the implementations of the second aspect, in some other implementations, a number of an information column in the first base graph is the same as a number of an information column in the second base graph, and encoding the information bit sequence based on the first base graph, to obtain the LDPC codeword sequence includes: performing filling processing on an information column that is not included in the first base graph and that belongs to the second base graph.

For terms or features that are in the second aspect or the implementations of the second aspect and that are the same as those in the first aspect or the implementations of the first aspect, refer to the first aspect or the implementations of the first aspect. For technical effects of the second aspect or the implementations of the second aspect, refer to the technical effects of the first aspect or the implementations of the first aspect. Details are not described again in the second aspect.

According to a third aspect, a communication apparatus is provided. The apparatus is configured to perform the method provided in any one of the foregoing aspects or the implementations of the foregoing aspects. Specifically, the apparatus may include a unit and/or a module configured to perform the method provided in any one of the foregoing aspects or the implementations of the foregoing aspects, for example, a processing unit and/or a transceiver unit.

In an implementation, the apparatus is a transmit end device or a receive end device. When the apparatus is a transmit end device or a receive end device, the transceiver unit may be a transceiver, an input/output interface, or a communication interface, and the processing unit may be at least one processor. Optionally, the transceiver is a transceiver circuit. Optionally, the input/output interface is an input/output circuit.

In another implementation, the apparatus is a chip, a chip system, or a circuit used in a transmit end device or a receive end device. When the apparatus is the chip, the chip system, or the circuit used in the transmit end device or the receive end device, the transceiver unit may be an input/output interface, an interface circuit, an output circuit, an input circuit, a pin, a related circuit, or the like on the chip, the chip system, or the circuit; and the processing unit may be at least one processor, processing circuit, logic circuit, or the like.

According to a fourth aspect, a communication apparatus is provided. The apparatus includes: a memory, configured to store a program; and at least one processor, configured to execute the computer program or instructions stored in the memory, to perform the method provided in any one of the foregoing aspects or the implementations of the foregoing aspects.

In an implementation, the apparatus is a transmit end device or a receive end device.

In another implementation, the apparatus is a chip, a chip system, or a circuit used in a transmit end device or a receive end device.

According to a fifth aspect, a communication apparatus is provided. The apparatus includes at least one processor and a communication interface. The at least one processor is configured to obtain, through the communication interface, a computer program or instructions stored in a memory, to perform the method provided in any one of the foregoing aspects or the implementations of the foregoing aspects. The communication interface may be implemented by hardware or software.

In an implementation, the apparatus further includes the memory.

According to a sixth aspect, a processor is provided, configured to perform the methods provided in the foregoing aspects.

Unless otherwise specified, or if operations such as sending and obtaining/receiving related to the processor do not conflict with actual functions or internal logic of the operations in related descriptions, the operations may be understood as operations such as outputting, receiving, and inputting of the processor, or may be understood as sending and receiving operations performed by a radio frequency circuit and an antenna. This is not limited in this application.

According to a seventh aspect, a computer-readable storage medium is provided. The computer-readable medium stores program code to be executed by a device. The program code is used to perform the method provided in any one of the foregoing aspects or the implementations of the foregoing aspects.

According to an eighth aspect, a computer program product including instructions is provided. When the computer program product runs on a computer, the computer is enabled to perform the method provided in any one of the foregoing aspects or the implementations of the foregoing aspects.

According to a ninth aspect, a chip is provided. The chip includes a processor and a communication interface. The processor reads, through the communication interface, instructions stored in a memory, to perform the method provided in any one of the foregoing aspects or the implementations of the foregoing aspects. The communication interface may be implemented by hardware or software.

Optionally, in an implementation, the chip further includes the memory. The memory stores a computer program or the instructions. The processor is configured to execute the computer program or the instructions stored in the memory. When the computer program or the instructions are executed, the processor is configured to perform the method provided in any one of the foregoing aspects or the implementations of the foregoing aspects.

When the method provided in this application is performed by a chip, a quantity of chips that specifically implement the method in this application is not limited in this application. For example, the method may be performed by one chip, or may be performed by two or more chips. In addition, when there are two or more chips that implement the method of this application, a chip vendor is not limited. The chips may be from a same vendor or different vendors.

According to a tenth aspect, a communication system is provided, including at least one of the transmit end device or the receive end device described above.

According to an eleventh aspect, a computer program is provided. The computer program, when run on a computer, enables the method provided in any one of the foregoing aspects or the implementations of the foregoing aspects to be performed.

## BRIEF DESCRIPTION OF DRAWINGS

FIG. 1 is a diagram of a network architecture to which an embodiment of this application may be applied;
FIG. 2 is a diagram of a check matrix H of LDPC;
FIG. 3 is a Tanner (Tanner) graph of a check matrix H of LDPC;
FIG. 4 is a diagram of a structure of a check matrix;
FIG. 5 is a diagram of an information transmission procedure;
FIG. 6 is a schematic flowchart of an LDPC code-based communication method 600 according to this application;
FIG. 7 shows an example of two cases of a table corresponding to a first base graph;
FIG. 8 is a diagram of a coding chain according to an embodiment of this application;
FIG. 9 shows simulation results 1 of signal-to-noise ratios (signal-noise ratio, SNR) of LDPC codes at different code rates;
FIG. 10 shows simulation results 2 of SNRs of LDPC codes at different code rates;
FIG. 11 shows simulation results 1 of signal-to-noise ratios of LDPC codes in different information lengths and at different code rates;
FIG. 12 shows simulation results 2 of signal-to-noise ratios of LDPC codes in different information lengths and at different code rates;
FIG. 13 shows simulation results of quantities of equivalent decoded QC blocks of different base graphs of an LDPC code according to this application;
FIG. 14 is a diagram of a structure of an apparatus according to an embodiment of this application;
FIG. 15 is a diagram of another structure of an apparatus according to an embodiment of this application; and
FIG. 16 is a diagram of a chip system according to an embodiment of this application.

## DESCRIPTION OF EMBODIMENTS

For ease of understanding embodiments of this application, before embodiments of this application are described, the following several points are described first.

"Indicating" or "indicate" may include direct indicating and indirect indicating, or in other words, "indicating" or "indicate" may be explicitly and/or implicitly indicating. First, second, and various numbers are merely used for differentiation for ease of description, for example, distinguishing between different messages or different information, and are not used to limit the scope of embodiments of this application. "Predefinition" may be implemented by prestoring corresponding code or a corresponding table in a device, or may be implemented in another manner in which related information may be indicated. A specific implementation of the "predefinition" is not limited in this application. A related "protocol" may be a standard protocol in the communication field, for example, may include a long term evolution (long term evolution, LTE) protocol, a new radio (new radio, NR) protocol, and a related protocol applied to a future communication system. This is not limited in this application. Words such as "exemplary", "for example", "example", and "in an/another example" are used to represent giving an example, an illustration, or a description. Any embodiment or design scheme described as an "example" in this application should not be explained as being more preferred or having more advantages than another embodiment or design scheme. The terms "include", "comprise", "have", and their variants all mean "include but are not limited to", unless otherwise specifically emphasized. "At least one" means one or more, and "a plurality of" means two or more. "At most one" means one or zero. The term "and/or" describes an association relationship for describing associated objects and represents that three relationships may exist. For example, A and/or B may represent the following three cases: Only A exists, both A and B exist, and only B exists, where A and B may be singular or plural. The character "/" usually indicates an "or" relationship between the associated objects. At least one of the following items (pieces) or a similar expression thereof indicates any combination of these items, including a single item (piece) or any combination of a plurality of items (pieces). For example, at least one of a, b, and c may represent: a, b, c, a and b, a and c, b and c, or a, b, and c, where a, b, and c each may be singular or plural. Related descriptions about that a network element A sends a message, information, or data to a network element B, and the network element B receives the message, information, or data from the network element A are intended to clarify the network element to which the message, information, or data is sent. Whether the message, information, or data is directly sent or is indirectly sent via another network element is not limited. Descriptions such as "when...", "in a case of...", "in response to", and "if" all mean that a device performs corresponding processing in a specific objective situation, where time is not limited, the device is not necessarily required to perform a determining action during implementation, and there are no other limitations.

In addition, a network architecture and a service scenario described in embodiments of this application are intended to describe the technical solutions in embodiments of this application more clearly, and do not constitute a limitation on the technical solutions provided in embodiments of this application. A person of ordinary skill in the art may know that with evolution of the network architecture and emergence of a new service scenario, the technical solutions provided in embodiments of this application are also applicable to similar technical problems.

The following describes communication systems to which embodiments of this application may be applied.

Embodiments of this application are applicable to various communication systems, including but not limited to a 5th generation (5th generation, 5G) system or an NR system, an LTE system, a long term evolution-advanced (long term evolution-advanced, LTE-A) system, an LTE frequency division duplex (frequency division duplex, FDD) system, an LTE time division duplex (time division duplex, TDD) system, and the like. Embodiments of this application are further applicable to a future communication system, for example, a 6th generation mobile communication system. In addition, embodiments of this application are further applicable to device to device (device to device, D2D) communication, vehicle-to-everything (vehicle-to-everything, V2X) communication, machine to machine (machine to machine, M2M) communication, machine type communication (machine type communication, MTC), an internet of things (internet of things, IoT) communication system, or another communication system. In addition, embodiments of this application may be further extended to a similar wireless communication system, for example, a communication system related to wireless fidelity (wireless fidelity, Wi-Fi), worldwide interoperability for microwave access (worldwide interoperability for microwave access, WiMAX), and the 3rd generation partnership project (3rd generation partnership project, 3GPP). This is not limited.

The communication system applicable to embodiments of this application may include one or more transmit end devices and one or more receive end devices. Optionally, one of the transmit end device and the receive end device may be a terminal device, and the other may be a network device. Optionally, both the transmit end device and the receive end device may be terminal devices. Optionally, both the transmit end device and the receive end device may be network devices.

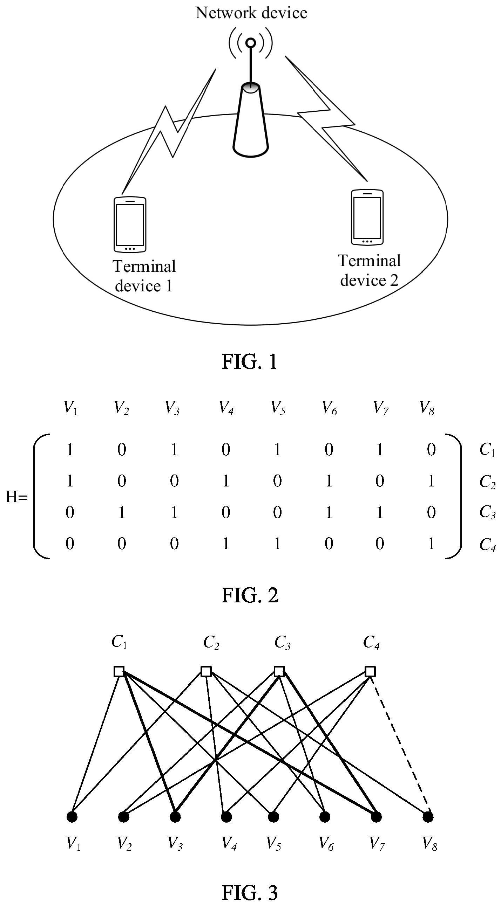

For example, FIG. 1 is a diagram of a network architecture to which an embodiment of this application may be applicable.

As shown in FIG. 1, embodiments of this application are applicable to both uplink data transmission and downlink data transmission. In FIG. 1, only uplink data transmission or downlink data transmission between one network device and two terminal devices (for example, a terminal device 1 and a terminal device 2) is used as an example. In uplink data transmission, in this specification, the transmit end device is a terminal device, and the receive end device is a network device. In downlink data transmission, the transmit end device is a network device, and the receive end device is a terminal device. In addition, applicability of embodiments of this application in another communication scenario is not limited. For example, embodiments of this application may also be applied to sidelink communication.

The terminal device in this application may also be referred to as user equipment (user equipment, UE), an access terminal, a subscriber unit, a subscriber station, a mobile station, a mobile terminal (mobile terminal, MT), a remote station, a remote terminal, a mobile device, a user terminal, a terminal, an uncrewed aerial vehicle, a wireless communication device, a user agent, or a user apparatus. The terminal device in embodiments of this application may be a device that provides voice and/or data connectivity for a user, and may be configured to connect a person, an object, and a machine, for example, a handheld device or a vehicle-mounted device having a wireless connection function. The terminal device in embodiments of this application may be a mobile phone (mobile phone), a tablet computer (pad), a notebook computer, a palmtop computer, a mobile internet device (mobile internet device, MID), a wearable device, a virtual reality (virtual reality, VR) device, an augmented reality (augmented reality, AR) device, a wireless terminal in industrial control (industrial control), a wireless terminal in self-driving (self-driving), a wireless terminal in remote medical surgery (remote medical surgery), a wireless terminal in a smart grid (smart grid), a wireless terminal in transportation safety (transportation safety), a wireless terminal in a smart city (smart city), a wireless terminal in a smart home (smart home), or the like.

The network device in this application may be a device having a wireless transceiver function. The network device may be a device that provides a wireless communication function service, is usually located on a network side, and includes but is not limited to a next generation base station (gNodeB, gNB) in a 5G system, a base station in a sixth generation mobile communication system, a base station in a future mobile communication system, an access node in a wireless fidelity (wireless fidelity, Wi-Fi) system, an evolved NodeB (evolved NodeB, eNB) in a long term evolution (long term evolution, LTE) system, a radio network controller (radio network controller, RNC), a NodeB (NodeB, NB), a base station controller (base station controller, BSC), a home base station (for example, a home evolved NodeB or a home NodeB, HNB), a base band unit (base band unit, BBU), a transmission reception point (transmission reception point, TRP), a transmission point (transmission point, TP), a base transceiver station (base transceiver station, BTS), a satellite, an unmanned aerial vehicle, and the like. In a network structure, the network device may include a central unit (central unit, CU) node, or a distributed unit (distributed unit, DU) node, or a RAN device including a CU node and a DU node, or a RAN device including a CU-control plane node, a CU-user plane node, and a DU node. Alternatively, the network device may be a radio controller, a relay station, a vehicle-mounted device, a wearable device, and the like in a cloud radio access network (cloud radio access network, CRAN) scenario. In addition, the base station may be a macro base station, a micro base station, a relay node, a donor node, or a combination thereof. The base station may alternatively be a communication module, a modem, or a chip that is disposed in the foregoing device or apparatus. The base station may alternatively be a mobile switching center, a device that bears a base station function in D2D, V2X, and M2M communication, a network side device in a 6G network, a device that bears a base station function in a future communication system, or the like. The base station can support networks using a same access technology or different access technologies. This is not limited.

Unless otherwise specified, the apparatus used to implement a function of the terminal device or the network device in this application may be the terminal device or the network device, or may be an apparatus that can support the terminal device or the network device in implementing the function, for example, a chip system or a chip, and more specifically, a system on a chip (system on a chip, SoC), or a modem (Modem). The apparatus may be mounted in the terminal device or the network device. In embodiments of this application, the chip system may include a chip, or may include a chip and another discrete component.

It should be further noted that in some embodiments of this specification, a 5G system is used as an example to describe specific solution details. It may be understood that when the solution is applied to another communication system, for example, an LTE system or a future communication system, messages, channels, information, or the like in the solution may be replaced with messages, channels, information, or the like that can implement corresponding functions in the another communication system. This is not limited in this application.

To facilitate understanding of embodiments of this application, several concepts or terms in embodiments of this application are briefly described. Concepts or terms described below are described based on concepts or terms specified in a protocol. However, this does not mean that embodiments of this application can be applied only to a current existing system, and concepts or terms in embodiments of this application can be applied to a future system. In addition, a specific name of a concept or a term (for example, a concept or a term related to functional description) may be adjusted with development of a future system.

1. LDPC code

The LDPC code is a linear block code, and a check matrix of the LDPC code is a sparse matrix. In the check matrix of the LDPC code, a quantity of zero elements is far greater than a quantity of non-zero elements. In other words, a row weight and a column weight of the check matrix are much less than a code length of the LDPC code. An LDPC code whose information bit sequence length is equal to k and whose code length is equal to n may be uniquely determined based on a check matrix of the LDPC code.

In 1981, Tanner (Tanner) represented LDPC codewords in a graph. This graph now is referred to as a Tanner graph. The Tanner graph and a check matrix are in a one-to-one correspondence. The Tanner graph includes two types of vertices. One type of vertex indicates codeword bits and is referred to as a variable node. The other type of vertex is a check node and indicates a check constraint relationship. Each check node indicates one check constraint relationship. The following provides descriptions with reference to FIG. 2 and FIG. 3.

FIG. 2 is a diagram of a check matrix H of LDPC.

In FIG. 2, $\{V_i\}$ represents a variable node (variable node, VN) set, and $\{C_i\}$ represents a check node (check node, CN) set. In the check matrix H, each row indicates one check equation, each check equation corresponds to one check node, each column indicates one codeword bit, and each codeword bit corresponds to one variable node. In FIG. 2, there are eight variable nodes and four check nodes. If a codeword bit is included in a corresponding check equation, related variable nodes and check nodes are connected by using a connection line, to obtain a Tanner graph.

FIG. 3 is a Tanner graph of a check matrix H of LDPC.

As shown in FIG. 3, the Tanner graph indicates the check matrix of the LDPC. For example, for the check matrix H having m rows and n columns, the Tanner graph includes two types of nodes: n variable nodes and m check nodes. The n variable nodes respectively correspond to the n columns of the check matrix H, and the m check nodes respectively correspond to the m rows of the check matrix H. A cycle in the Tanner graph consists of connected vertices. The cycle uses one of the vertices as both a start point and an end point, and passes through each node only once. A length of the cycle is defined as a quantity of connection lines included in the cycle. A girth of a graph may also be referred to as a size of the graph, and is defined as a shortest cycle length in the graph. In FIG. 3, a girth is 4, as shown by bold connection lines in FIG. 3. The variable nodes in the Tanner graph each correspond to one column of the check matrix H, that is, correspond to each LDPC codeword bit. The check nodes in the Tanner graph each correspond to one row of the check matrix H, that is, correspond to each LDPC parity bit. A connection between the two types of nodes corresponds to a value of an element in the matrix H. If there is a connection between an $i^{th}$ check node and a $j^{th}$ variable node, it indicates that a value of an element $(i, j)$ in the matrix H is 1. If there is no connection between an $i^{th}$ check node and a $j^{th}$ variable node, it indicates that a value of a corresponding element is 0. A connection line between a variable node and a check node may also be referred to as a connection edge. That there is a connection between a check node and a variable node may also be described as that there is a connection or a connection edge between the check node and the variable node. A connection edge relationship between the check node and the variable node may include two cases: a connection edge exists or a connection edge does not exist.

In addition, in the Tanner graph, a cycle (cycle) is a closed loop formed by variable nodes, check nodes, and connection edges that are connected end to end.

As described above, the LDPC is a linear block code. In the linear block code, a to-be-encoded information sequence is divided into groups in k bits, and an encoder performs a linear operation on the k information bits to obtain m parity bits. Then, the k information bits are combined with the m parity bits to obtain a codeword whose length is n=k+m. A mapping relationship between the information bits of k bits and the codeword whose length is n bits is usually represented by a corresponding check matrix H. A codeword sequence may be correspondingly generated based on the check matrix H to complete an encoding process. After the codeword sequence is transmitted through a channel, a receive end device correspondingly decodes a received signal, to determine an original information bit.

2. QC-LDPC code

The quasi-cyclic low-density parity check (quasi-cyclic low-density parity check, QC-LDPC) code is a type of structured LDPC code. Due to a unique structure of a check matrix of the QC-LDPC code, a simple feedback shift register may be used during encoding, to reduce encoding complexity of the LDPC code. When a code length is long, the check matrix H of the LDPC code is very large. Therefore, H is usually represented by blocks. A complete check matrix H is considered to be generated by a plurality of $Z_c \times Z_c$ submatrixes. Specifically, the complete check matrix H may be represented by one base matrix $H_b$, each element in $H_b$ corresponds to one $Z_c \times Z_c$ submatrix, and each submatrix may be represented by a quantity of cyclic shift bits. Therefore, storage space required by the complete check matrix H is greatly reduced. An element in the base matrix $H_b$ may also be referred to as a quasi-cyclic (quasi-cyclic, QC) block.

Based on the base matrix $H_b$ and a lifting size $Z_c$ (lifting size), the base matrix $H_b$ may be extended into a complete check matrix for encoding or decoding. $Z_c$ may also be referred to as an extension factor, a lifting factor, an extension value, an extension coefficient, a lifting size, or the like.

For example, the base matrix $H_b$ of the QC-LDPC code is shown as follows:

$$
\begin{bmatrix}
13 & 48 & 80 & 66 & 4 & 74 & 7 & 30 & 76 & 52 & 37 & 60 & -1 & 49 & -1 & 73 & 31 & 74 & 73 & 23 & 1 & 0 & -1 & -1 \\
69 & 63 & 74 & 56 & 64 & 77 & 57 & 65 & 6 & 16 & 51 & -1 & 64 & -1 & 64 & 68 & 9 & 48 & 62 & 54 & -1 & 0 & 0 & -1 \\
51 & 15 & 0 & 80 & 24 & 25 & 42 & 54 & 44 & 71 & 71 & 9 & 67 & 35 & 67 & -1 & 58 & -1 & 29 & -1 & 0 & -1 & 0 & 0 \\
16 & 29 & 36 & 41 & 44 & 56 & 59 & 37 & 50 & 24 & -1 & 65 & 4 & 65 & 4 & 52 & -1 & 4 & -1 & 73 & 1 & -1 & -1 & 0
\end{bmatrix}
$$

It can be learned that the base matrix $H_b$ has 4 rows and 24 columns, each element in the base matrix $H_b$ represents a $Z_c$-order square matrix, an element $P_{Z_c}^i$ represents a cyclic permutation matrix, i represents a cyclic shift value, and i is an integer. In addition, in the base matrix $H_b$, "-1" represents an all-zero matrix, and "0" represents a unit matrix.

For example, $P_{Z_c}^1$ is as follows:

$$P_{Z_c}^1 = \begin{bmatrix} 0 & 1 & 0 & ... & 0 \\ 0 & 0 & 1 & ... & 0 \\ \vdots & \vdots & \vdots & \ddots & \vdots \\ 0 & 0 & 0 & ... & 1 \\ 1 & 0 & 0 & ... & 0 \end{bmatrix}$$

Optionally, in addition to "-1", a zero element in the base matrix $H_b$ may also be expressed in another form. For example, "-" or a null value is used to represent the all-zero matrix.

3. Non-zero element and zero element

In the check matrix, the zero element indicates that there is no connection between the variable node and the check node, and the non-zero element indicates that there is a connection between the variable node and the check node.

In an LDPC base matrix, the zero element represents a $Z_c$-order all-zero square matrix, the non-zero element represents a $Z_c$-order unit matrix or a cyclic permutation matrix based on a $Z_c$-order unit matrix, and a value of the non-zero element represents a cyclic shift value or a shifting value (shifting value) relative to the unit matrix.

Specific representation forms of the zero element and the non-zero element are not limited in this application. For example, in the check matrix H shown in FIG. 2, "0" is used to represent the zero element, and "1" is used to represent the non-zero element. For another example, in the base matrix $H_b$ described above, "-1" is used to represent the zero element, and a "non-negative value" is used to represent the non-zero element.

4. Column weight and row weight

For a specific column of a matrix, the column weight may be a quantity of non-zero elements included in the column. For a specific row of a matrix, the row weight may be a quantity of non-zero elements included in the row. For example, as shown in FIG. 2, a column weight of a first column of the check matrix H is 2, and a row weight of a first row is 4. For another example, in the foregoing base matrix $H_b$, a column weight of a first column is 4, and a row weight of a first row is 20.

5. Structure of a check matrix

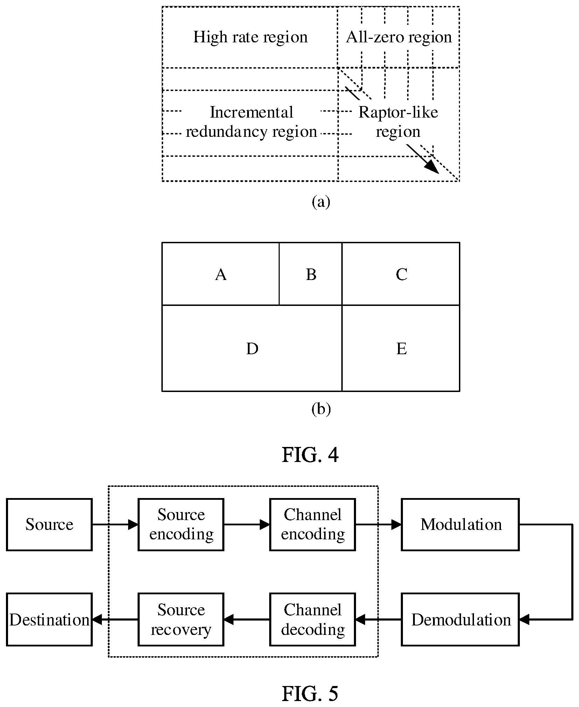

FIG. 4 is a diagram of a structure of a check matrix.

As shown in (a) in FIG. 4, the check matrix may include a high rate region (high rate region), an all-zero region, an incremental redundancy region (incremental redundancy region), and a raptor-like region (raptor-like region). The high rate region may include a part A and a part B shown in (b) in FIG. 4. The part A corresponds to an information bit (or referred to as an information digit, a system bit, or the like), and the part B is a square matrix and corresponds to a core check bit (or referred to as a core check digit). The all-zero region may correspond to a part C in (b) in FIG. 4, and is an all-zero matrix. An incremental redundancy region (incremental redundancy region) may correspond to a part D in (b) in FIG. 4. The raptor-like region may correspond to a part E in (b) in FIG. 4, may be a unit matrix, and corresponds to a check bit extended at a low code rate.

The check matrix of the LDPC code shown in FIG. 4 uses a "raptor-like" structure, and may be gradually extended to a low code rate by using a core matrix with a high code rate. In actual use, as shown in (a) in FIG. 4, first X rows and first Y columns of the check matrix may be extracted. As a code rate increases from high to low, X and Y gradually increase, and an area in which the matrix is used also gradually increases.

It should be noted that the check matrix may be represented by an LDPC base matrix. Therefore, a structure of the LDPC base matrix is similar to a structure of the check matrix, and details are not described herein again.

6. Information column, check column, and core column

Columns of an LDPC base matrix include information columns and check columns.

The information columns correspond to information bits (or referred to as information digits, system bits, or the like), and are columns corresponding to the part A.

The check columns correspond to check bits (or check digits), and may include core check columns and extended check columns, where the core check columns are columns corresponding to the part B, and the extended check column are columns corresponding to the part C or the part E. The extended check columns may also be referred to as raptor-like columns.

The core columns include all information columns and all core check columns. In other words, the core columns are columns corresponding to a high rate region, or columns corresponding to the part A and the part B.

7. Punctured column

The punctured column in the LDPC code may be a column that is not sent. The punctured column may be an information column, or may be a check column. In this application, an information column that is punctured is referred to as a punctured information column for short, and a check column that is punctured is referred to as a punctured check column for short.

In addition, a column that is not punctured in the LDPC code may also be referred to as a non-punctured column. Similarly, the non-punctured column may be an information column, or may be a check column. In this application, an information column that is not punctured is referred to as a non-punctured information column for short, and a check column that is not punctured is referred to as a non-punctured check column for short.

8. Column grouping

The column grouping means that columns of a matrix are grouped based on a basic unit greater than one column. For example, it is assumed that a core column set is C, and the core column set C is divided into t subsets: $C_1$ to $C_t$. $C_1 \cup ... \cup C_t = C$, and an intersection set of any two subsets in the t subsets is empty, that is, $C_i \cap C_j = \emptyset$, $C_i \neq \emptyset$, and $C_j \neq \emptyset$.

Even column grouping means that each of the t subsets includes a same quantity of columns. Even column grouping of k is used as an example. For any subset $C_i$ in the t subsets, $|C_i| = k$, where $|C_i|$ is a quantity of columns included in the subset $C_i$.

Uneven column grouping means that there are at least two subsets in the t subsets, and the two subsets include different quantities of columns.

9. Row grouping

The row grouping means that rows of a matrix are grouped based on a basic unit greater than or equal to one row. For example, it is assumed that a row set of the matrix is R, and the row set R is divided into s subsets: $R_1$ to $R_s$. $R_1 \cup ... \cup R_s = R$, and an intersection set of any two subsets in the s subsets is empty, that is, $R_i \cap R_j = \emptyset$, $R_i \neq \emptyset$, and $R_j \neq \emptyset$.

Even row grouping means that each of the s subsets includes a same quantity of rows. Even row grouping of q rows is used as an example. For any subset $R_i$ in the s subsets, $|R_i| = q$, where $|R_i|$ is a quantity of rows included in the subset $R_i$.

Uneven row grouping means that there are at least two subsets in the s subsets, and the two subsets include different quantities of rows.

10. Information transmission procedure

FIG. 5 is a diagram of an information transmission procedure. As shown in FIG. 5, information is sent by a source, and after processing such as source encoding, channel encoding, modulation, air interface transmission, demodulation, channel decoding, and source recovery, the information reaches a destination, so that transmission of the information from the source to the destination is completed. In FIG. 5, processing (including source encoding, channel encoding, modulation, and the like) shown at an upper layer is performed at a transmit end device, and processing (including demodulation, channel decoding, source recovery, and the like) shown at a lower layer is performed at a receive end device. Embodiments of this application mainly relate to source encoding, channel encoding, channel decoding, and source recovery shown in FIG. 5.

It should be noted that the base matrix may also be referred to as a base graph (base graph, BG). The following describes embodiments of this application based on the base graph.

Currently, an LDPC code (for example, an NR LDPC code) relates to selection of a plurality of base graphs.

Specifically, a current standard protocol specifies that two base graphs, namely a BG 1 and a BG 2, are stored, the BG 2 is used when an information length is less than or equal to 292, or an information length is less than or equal to 3840 and a code rate is less than or equal to 2/3, or a code rate is less than or equal to 0.25, and the BG 1 is used in other cases.

In the future, there may be more application scenarios, and more base graphs are required. Content stored in a device becomes very complex. Correspondingly, descriptions in a standard protocol are also very complex.

In view of the foregoing problems, this application provides an LDPC code-based communication method and a communication apparatus. There is a nested relationship between base graphs, so that a base graph of a small scale can be derived based on a base graph of a large scale. The communication apparatus may store a base graph of a largest scale. When another base graph needs to be used for encoding or decoding, the communication apparatus may derive a required base graph based on the base graph of the largest scale. In this way, content that needs to be stored by the communication apparatus can be reduced.

The following describes method embodiments of this application with reference to the accompanying drawings.

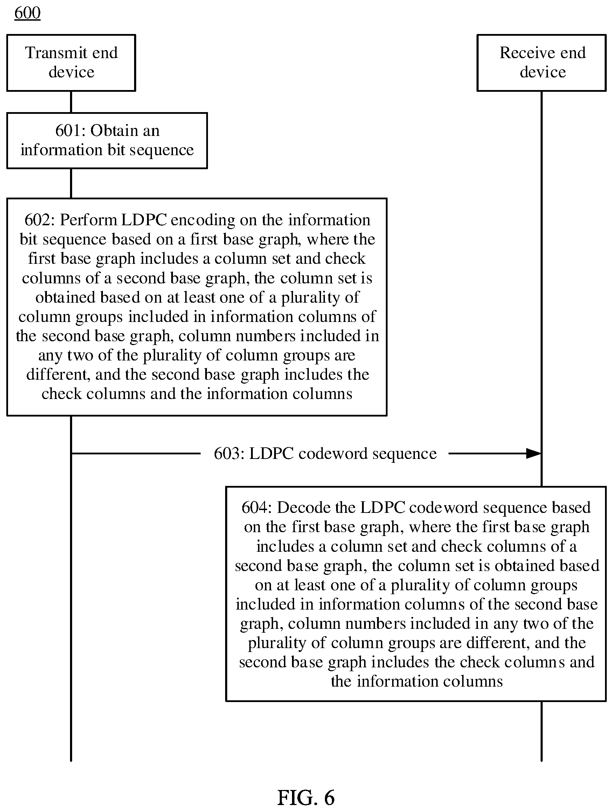

FIG. 6 is a schematic flowchart of an LDPC code-based communication method 600 according to this application.

The method 600 may be performed by a transmit end device and a receive end device. Unless otherwise specified, a "transmit end device" or a "receive end device" may be the transmit end device or the receive end device, or may be an apparatus that can support the transmit end device or the receive end device in implementing the function. For ease of description, the transmit end device and the receive end device are used for description in the following. The transmit end device may be a terminal device or a network device, and the receive end device may be a terminal device or a network device.

The method 600 may include at least a part of the following content.

Step 601: The transmit end device obtains an information bit sequence.

In other words, if the transmit end device needs to communicate with the receive end device, the transmit end device needs to send a signal to the receive end device, the transmit end device needs to first obtain an information bit sequence corresponding to the signal that needs to be sent to the receive end device.

That the transmit end device obtains the information bit sequence may be: The transmit end device performs source encoding on a source symbol to generate the information bit sequence. That the transmit end device obtains the information bit sequence may alternatively be: The transmit end device receives the information bit sequence from another communication apparatus.

Step 602: The transmit end device performs LDPC encoding on the information bit sequence based on a first base graph.

The first base graph includes a first column set and check columns of a second base graph, the first column set is obtained based on at least one of a plurality of column groups included in information columns of the second base graph, and the second base graph includes the check columns and the information columns. In other words, the first base graph may be derived based on the second base graph, where check columns of the first base graph are the check columns of the second base graph, and the first column set (that is, an information column of the first base graph) of the first base graph is obtained based on at least one of the plurality of column groups included in the information columns of the second base graph.

It should be noted that the information columns of the base graph in this embodiment of this application are all information columns of the base graph. When there is a punctured information column in the base graph, the information column of the base graph includes a punctured information column and non-punctured information columns. Similarly, the check columns of the base graph in this embodiment of this application are all check columns of the base graph, and the check columns of the base graph include core check columns and extended check columns. Similar descriptions in other positions in the specification are not described.

The second base graph may include a punctured information column, or may not include a punctured information column. This is not limited in this application.

When the second base graph does not include the punctured information column, the plurality of column groups included in the information column of the second base graph may be a plurality of column groups obtained by dividing all information columns of the second base graph. In other words, the plurality of column groups include all information columns of the second base graph. In this case, the first column set may include columns selected based on the plurality of column groups. In other words, in a process of obtaining the first base graph based on the second base graph, all information columns of the second base graph are screened or selected.

When the second base graph includes the punctured information column, in a possible implementation, the plurality of column groups included in the information columns of the second base graph may be a plurality of column groups obtained by dividing the non-punctured information columns of the second base graph. In other words, the plurality of column groups include the non-punctured information columns of the second base graph. In this case, the first column set may include columns selected based on the plurality of column groups and the punctured information column of the second base graph. In other words, in a process of obtaining the first base graph based on the second base graph, the punctured information column of the second base graph is reserved, and the non-punctured information columns of the second base graph are screened or selected.

When the second base graph includes the punctured information column, in another possible implementation, the plurality of column groups included in the information columns of the second base graph may be a plurality of column groups obtained by dividing the punctured information column and the non-punctured information columns of the second base graph together. In other words, the plurality of column groups include the punctured information column and the non-punctured information columns of the second base graph. In this case, the first column set may include columns selected based on the plurality of column groups. In other words, in a process of obtaining the first base graph based on the second base graph, both the punctured information column and the non-punctured information columns of the second base graph are screened or selected.

For "division" in step 602, refer to "column grouping" in the term explanation part. Details are not described herein again.

Scales of the plurality of column sets in this embodiment of this application may be the same or may be different. In other words, quantities of columns in each column set may be the same or may be different. This is not limited. The following describes this embodiment of this application by using an example in which the plurality of column sets have a same scale. Column numbers included in any two of the plurality of column sets are different, and column numbers included in the plurality of column sets are consecutive. For example, it is assumed that the second base graph includes 24 information columns. For example, all information columns of the second base graph are grouped. When a column group scale is 2, the information columns of the second base graph may be divided into 11 column groups, and the 11 column groups are respectively {1, 2}, {3, 4}, {5, 6}, {7, 8}, {9, 10}, {11, 12}, {13, 14}, {15, 16}, {17, 18}, {19, 20}, {21, 22}, and {23, 24}. When a column group scale is 3, the information columns of the second base graph may be divided into 8 column groups, and the 8 column groups are respectively {1, 2, 3}, {4, 5, 6}, {7, 8, 9}, {10, 11, 12}, {13, 14, 15}, {16, 17, 18}, {19, 20. 21}, and {22, 23, 24}: When a column group scale is 4, the information columns of the second base graph may be divided into 6 column groups, and the 6 column groups are respectively {1, 2, 3, 4}, {5, 6, 7, 8}, {9, 10, 11, 12}, {13, 14, 15, 16}, {17, 18, 19, 20}, and {21, 22, 23, 24}.

In some implementations, the second base graph is a base graph of a largest scale stored in the transmit end device, and another base graph required by the transmit end device may be derived from the second base graph. For example, the second base graph is a BG 1, and a BG x may be derived from the BG 1, where x is greater than or equal to 2. Optionally, the transmit end device may store only the second base graph. When the transmit end device needs to use another base graph, the transmit end device may derive the required base graph based on the second base graph. In this case, content stored in the transmit end device may be simplified. Optionally, the transmit end device may store the second base graph and some or all of the base graphs that may be derived from the second base graph.

In some other implementations, the second base graph is a base graph that may be derived from a base graph of a largest scale stored in the transmit end device. In other words, in a process of obtaining the base graph required by the transmit end device, the transmit end device may first derive the second base graph from the stored base graph of the largest scale, and then derive the first base graph from the second base graph. For example, the transmit end device needs to perform encoding by using a BG 3, and the transmit end device may derive a BG 2 based on a BG 1 of a largest scale, and then derive the BG 3 from the BG 2. Optionally, the transmit end device may store a base graph of a largest scale. When the transmit end device needs to use another base graph, the transmit end device may derive the required base graph based on the base graph of the largest scale. In this case, content stored in the transmit end device may be simplified. Optionally, the transmit end device may store the second base graph and some or all of base graphs that may be derived from the base graph of the largest scale.

In this embodiment of this application, for a design of a quantity of information columns of a base graph of a largest scale and a design of a quantity of columns of each column group, a base graph that can be compatible with the base graph of the largest scale needs to be considered. For example, if a base graph that may be used by the transmit end device includes a BG 1, a BG 2, and a BG 3, during base graph design, the base graph of the largest scale needs to support deriving the BG 1, the BG 2, and the BG 3. A supported maximum code rate also needs to be considered, and a highest code rate herein may be equal to a highest code rate in an MCS in 5G NR or higher than a highest code rate in an MCS in 5G NR.

For example, it is assumed that the base graph of the largest scale is a BG 1, and a BG 2 and a BG 3 may be derived from the BG 1. The BG 1 is designed to adapt to a higher code rate, and a highest code rate supported by a core matrix of the BG 1 may be higher than the highest code rate in the MCS in 5G NR. The BG 1 may be applied to encoding and decoding in a high-rate scenario. A matrix scale of the BG 2 is completely the same as that of the BG 1 in 5G NR, and a code rate of a core matrix of the BG 2 is consistent with a code rate that can be supported by the BG 1 in 5G NR. A matrix scale of the BG 3 is close to that of the BG 2 in 5G NR, and some check rows may be added. The BG 3 may support a same low code rate part as the BG 2 in 5G NR, and may support a code rate higher than that of the BG 2 in 5G NR.

For example, a quantity of columns included in the plurality of column groups of the base graph of the largest scale is 26, and a quantity of columns included in each of the plurality of column groups is 2. When the plurality of column groups include all information columns of the base graph, a quantity of information columns of the base graph is 26. When the plurality of column groups include all non-punctured information columns of the base graph, a quantity of information columns of the base graph is 26 plus a quantity of punctured information columns.

For another example, a quantity of columns included in the plurality of column groups of the base graph of the largest scale is 33, and a quantity of columns included in each of the plurality of column groups is 3. When the plurality of column groups include all information columns of the base graph, a quantity of information columns of the base graph is 33. When the plurality of column groups include all non-punctured information columns of the base graph, a quantity of information columns of the base graph is 33 plus a quantity of punctured information columns.

For another example, a quantity of columns included in the plurality of column groups of the base graph of the largest scale is 30, and a quantity of columns included in each of the plurality of column groups is 3. When the plurality of column groups include all information columns of the base graph, a quantity of information columns of the base graph is 30. When the plurality of column groups include all non-punctured information columns of the base graph, a quantity of information columns of the base graph is 30 plus a quantity of punctured information columns.

For another example, a quantity of columns included in the plurality of column groups of the base graph of the largest scale is 36, and a quantity of columns included in each of the plurality of column groups is 4. When the plurality of column groups include all information columns of the base graph, a quantity of information columns of the base graph is 36. When the plurality of column groups include all non-punctured information columns of the base graph, a quantity of information columns of the base graph is 36 plus a quantity of punctured information columns.

For another example, a quantity of columns included in the plurality of column groups of the base graph of the largest scale is 40, and a quantity of columns included in each of the plurality of column groups is 4. When the plurality of column groups include all information columns of the base graph, a quantity of information columns of the base graph is 40. When the plurality of column groups include all non-punctured information columns of the base graph, a quantity of information columns of the base graph is 40 plus a quantity of punctured information columns.

The quantity of the punctured information columns included in the base graph of the largest scale is not limited in this embodiment of this application. For example, the quantity of the punctured information columns included in the base graph of the largest scale is 0, 1, or 2.

In this embodiment of this application, the first column set used to form the first base graph may include some information columns of the second base graph. There are many implementations of deriving the first base graph from the second base graph. This is not limited in this application. The following describes in detail a manner of deriving the first base graph based on the second base graph.

A manner of deriving the first base graph from the second base graph may be: reserving all rows of the second base graph, reserving core check columns and extended check columns of the second base graph, and reserving some information columns of the second base graph. When the second base graph includes the punctured information column, an implementation of reserving some information columns of the second base graph is: reserving all non-punctured information columns of the second base graph and some non-punctured information columns of the second base graph; and another implementation is: using the punctured information column and the non-punctured information columns of the second base graph as a whole, and reserving some columns of the whole, where the reserved columns may include the punctured information column, or may not include the punctured information column.

A manner of selecting some information columns (namely, the first column set) of the second base graph based on the plurality of column groups is not specifically limited in this embodiment of this application. The following describes an example in which the second base graph is a base graph of a largest scale stored in the transmit end device, and the transmit end device stores only the second base graph.

(1) First possible implementation

A manner of selecting the first column set based on the plurality of column groups is: reserving an information column at a specific location in each of the plurality of column groups.

For example, a quantity of columns included in each of the plurality of column groups is k, the first column set includes an $i^{th}$ column to a $j^{th}$ column of each of the plurality of column groups, and j-i is a positive integer greater than 0 and less than k. For another example, a quantity of columns included in each of the plurality of column groups is k, the first column set includes an $m^{th}$ column of each of the plurality of column groups, and m is a positive integer greater than 0 and less than k.

For example, core columns of the second base graph include 22 information columns and four core check columns, where a $1^{st}$ column and a $2^{nd}$ column are punctured columns, a $3^{rd}$ column to a $22^{nd}$ column are non-punctured information columns, and a $23^{rd}$ column to a $26^{th}$ column are core check columns. For example, k=2, m=1, and the plurality of column groups include 22 information columns. The plurality of column groups are respectively {1, 2}, {3, 4}, {5, 6}, {7, 8}, {9, 10}, {11, 12}, {13, 14}, {15, 16}, {17, 18}, {19, 20}, and {21, 22}. A $1^{st}$ column set obtained by reserving a $1^{st}$ column of each column group is {1, 3, 5, 7, 9, 11, 13, 15, 17, 19, 21}. In this way, a core column of the first base graph is {1, 3, 5, 7, 9, 11, 13, 15, 17, 19, 21, 23, 24, 25, 26}, and a scale of the first base graph is 11 information columns and four core check columns, where one of the 12 information columns is a punctured information column. For example, k=2, m=1, and the plurality of column groups include 20 non-punctured information columns. The plurality of column groups are respectively {3, 4}, {5, 6}, {7, 8}, {9, 10}, {11, 12}, {13, 14}, {15, 16}, {17, 18}, {19, 20}, and {21, 22}. A 1st column set obtained by reserving a punctured information column of the second base graph and a 1st column of each column group is {1, 2, 3, 5, 7, 9, 11, 13, 15, 17, 19, 21}. In this way, a core column of the first base graph is {1, 2, 3, 5, 7, 9, 11, 13, 15, 17, 19, 21, 23, 24, 25, 26}, and a scale of the first base graph is 12 information columns and four core check columns, where two of the 12 information columns are punctured information columns.

For another example, the information columns of the second base graph are 33 columns, and the second base graph may include a punctured information column, or may not include a punctured information column. For example, k=3, i=1, j=2, and the plurality of column groups include 33 information columns. The information columns of the second base graph are divided into 11 groups, the plurality of column groups are respectively {1, 2, 3}, {4, 5, 6}, {7, 8, 9}, {10, 11, 12}, {13, 14, 15}, {16, 17, 18}, {19, 20, 21}, {22, 23, 24}, {25, 26, 27}, {28, 29, 30}, and {31, 32, 33}, and a first column set obtained by reserving a 1st column and a 2nd column in each column group is {1, 2, 4, 5, 7, 8, 10, 11, 13, 14, 16, 17, 19, 20, 22, 23, 25, 26, 28, 29, 31, 32}. In this way, a scale of the first base graph is 22 information columns, and the first base graph does not include a punctured information column.

For another example, the information columns of the second base graph are 35 columns, where a 1st column and a 2nd column are punctured information columns, and a 3rd column to a 35th column are non-punctured information columns. For example, k=3, i=1, j=2, and the plurality of column groups include 33 non-punctured information columns. The non-punctured information columns of the second base graph are divided into 11 groups, the plurality of column groups are respectively {3, 4, 5}, {6, 7, 8}, {9, 10, 11}, {12, 13, 14}, {15, 16, 17}, {18, 19, 20}, {21, 22, 23}, {24, 25, 26}, {27, 28, 29}, {30, 31, 32}, and {33, 34, 35}, and a first column set obtained by reserving the punctured information columns of the second base graph and the 1st column and the 2nd column of each column group is {1, 2, 3, 4, 6, 7, 9, 10, 12, 13, 15, 16, 18, 19, 21, 22, 24, 25, 27, 28, 30, 31, 33, 34}. In this way, a scale of the first base graph is 24 information columns, including 22 non-punctured information columns and two punctured information columns.

For another example, the information columns of the second base graph are 26 columns, where a 1st column and a 2nd column are punctured information columns, and a 3rd column to a 26th column are non-punctured information columns. For example, k=4, i=2, j=4, and the plurality of column groups include 24 information columns. The non-punctured information columns of the second base graph are divided into six groups, and the plurality of column groups are {3, 4, 5, 6}, {7, 8, 9, 10}, {11, 12, 13, 14}, {15, 16, 17, 18}, {19, 20, 21, 22} and {23, 24, 25, 26}. A first column set obtained by reserving the punctured information columns of the second base graph and a 2nd column to a 4th column of each column group is {1, 2, 4, 5, 6, 8, 9, 10, 12, 13, 14, 16, 17, 18, 20, 21, 22, 24, 25, 26}. In this way, a scale of the first base graph is 20 information columns, including 18 non-punctured information columns and two punctured information columns.

In a first possible implementation, only the second base graph, the column groups of the second base graph, and a derivation principle indicating that a specific location of each column group is reserved need to be described in the standard protocol. The derivation principle corresponds to the first base graph. The description in the standard protocol is very concise. Correspondingly, the first base graph does not need to be stored in the device, and stored content is very simple, and implementation of the device is also very simple.

Optionally, some or all rows of the second base graph in this embodiment of this application may include a plurality of row groups, and the plurality of row groups and the plurality of column groups may form a plurality of grouping structures or grouping units. For example, a 1st row to a 46th row of the second base graph are divided into 23 row groups whose scales are two rows, and a 1st column to a 22nd column of the second base graph are divided into 11 column groups whose scales are two columns. The 23 row groups and the 11 column groups may form 253 grouping units. In other words, a matrix region including the 1st row to the 46th row and the 1st column to the 22nd column in the second base graph includes or is divided into 253 grouping units with two rows and two columns. A column weight of a column of a grouping unit included in the second base graph is not greater than 1. Specifically, the grouping units included in the second base graph may be classified into three types. A column weight of each column of a first-type grouping unit is 1, a column weight of at least one column of a second-type grouping unit is 1 and a column weight of a remaining column is 0, and a column weight of each column of a third-type grouping unit is 0. Because the column weight of each column in the first-type grouping unit, the second-type grouping unit, and the third-type grouping unit is not greater than 1, the receive end device may perform parallel decoding on a plurality of QC blocks on a codeword sequence corresponding to each grouping unit, and a case in which decoding cannot be performed does not occur. This helps improve decoding performance. In addition, only the second-type grouping unit causes a waste of some hardware resources. Therefore, hardware utilization can be improved.

When the second base graph includes the foregoing plurality of grouping units, an advantage of the first possible implementation is that a connection edge density of the first base graph can be flexibly controlled, to ensure that the connection edge density of the first base graph is optimal. In addition, this implementation can ensure that the second base graph and the first base graph have more obvious dominant interval division.

(2) Second possible implementation

A manner of selecting the first column set based on the plurality of column groups is: reserving an information column at a non-specific location in each of the plurality of column groups.

For example, one first sequence may indicate columns reserved in each of the plurality of column groups, or the first sequence indicates columns that are in each of the plurality of column groups and that are used to form the first column set. In this implementation, the transmit end device may derive the first base graph based on the second base graph and the first sequence.

In a second possible implementation, one element in the first sequence may correspond to one column group, and the element indicates which columns in the column group corresponding to the element are reserved.

Table 1 is an example of the second possible implementation. As shown in Table 1, the second base graph includes a column group $S_1$ to a column group $S_9$, and each column group includes two columns. It is assumed that $S_1$ corresponds to punctured information columns, and $S_2$ to $S_9$ correspond to non-punctured information columns.

Optionally, the element in the first sequence may be a multi-tuple shown in a row 3 of Table 1. In the multi-tuple, 1 indicates that a column in a corresponding location is reserved, and 0 indicates that a column in a corresponding location is not reserved. Because each column group includes two columns, a 2-tuple may be used to represent an element in the first sequence. For example, a 1st 2-tuple (1, 1) in the 3rd row indicates that two columns in the column group $S_1$ are reserved, a 2nd 2-tuple (0, 0) indicates that columns in the column group $S_2$ are not reserved, and a 3rd 2-tuple (1, 0) indicates that a 1st column in the column group $S_3$ is reserved and a 2nd column in the column group $S_3$ is not reserved. The multi-tuple may also have another name, for example, a one-dimensional vector. This is not limited.

Optionally, an element in the first sequence may be modulated into a higher-order symbol. For example, a 2-tuple (0, 0) may be represented by a higher-order symbol 0, a 2-tuple (0, 1) may be represented by 1, a 2-tuple (1, 0) may be represented by a higher-order symbol 2, and a 2-tuple (1, 1) may be represented by a higher-order symbol 3.

Table 1

| Column group | $S_1$ | $S_2$ | $S_3$ | $S_4$ | $S_5$ | $S_6$ | $S_7$ | $S_8$ | $S_9$ |
|---|---|---|---|---|---|---|---|---|---|
| Columns included in a column group | 1, 2 | 3, 4 | 5, 6 | 7, 8 | 9, 10 | 11, 12 | 13, 14 | 15, 16 | 17, 18 |
| First sequence | 1, 1 | 0, 0 | 1, 0 | 0, 1 | 1, 1 | 1, 0 | 1, 0 | 1, 0 | 1, 0 |
| First sequence represented by a higher-order symbol | 3 | 0 | 2 | 1 | 3 | 2 | 2 | 2 | 2 |

In a second possible implementation, the second base graph, the column group of the second base graph, and the first sequence may be described in the standard protocol. The first sequence corresponds to the first base graph. The description in the standard protocol is very concise. Correspondingly, the device may store the second base graph, the column group of the second base graph, and the first sequence, and the first base graph does not need to be stored, and stored content is also very simple.

(3) Third possible implementation

A manner of selecting the first column set based on the plurality of column groups is: reserving all columns of each column group in a first set and some columns of each column group in a second set, and skip reserving columns in column groups other than the first set and the second set. The first set includes some column groups in the plurality of column groups, the second set includes some column groups in the plurality of column groups, and some column groups forming the first set are different from some column groups forming the second set. In addition, a total quantity of column groups included in the first set and the second set is less than or equal to a quantity of the plurality of column groups. In other words, the first column set includes all columns of each column group in the first set and some columns of each column group in the second set. In this implementation, the second base graph, the column group of the second base graph, first information, and second information may be described in the standard protocol. The first information and the second information correspond to the first base graph. The first information indicates the first set, for example, numbers of column groups in which all columns are reserved. For example, the first information is a column group set $\{S_1, S_2, S_3, S_4, S_5\}$, indicating that all columns of the column groups $S_1$, $S_2$, $S_3$, $S_4$, and $S_5$ are reserved. The second information indicates some columns of each column group in the second set, for example, numbers of column groups in which some columns are reserved and column numbers of corresponding reserved columns. For example, the second information is $\{(S_6, 1), (S_6, 2), (S_7, 1)\}$, indicating that a 1st column of the column group $S_6$, a 2nd column of the column group $S_6$, and a 1st column of the column group $S_7$ are reserved. Correspondingly, the device may store the second base graph, the column group of the second base graph, the first information, and the second information, and does not need to store the first base graph, and stored content is also very simple. In this implementation, the transmit end device may determine the first base graph based on the second base graph, the first information, and the second information.

For example, the first information indicates numbers of column groups in which all columns are reserved, and the second information indicates numbers of column groups in which some columns are reserved and column numbers of corresponding reserved columns.

For example, it is assumed that each column group includes three columns, the first information is a column group set $\{S_1, S_2, S_3, S_4, S_5\}$, and indicates that all columns of the column groups $S_1$, $S_2$, $S_3$, $S_4$, and $S_5$ are reserved; and the second information is $\{(S_6, 1), (S_6, 2), (S_7, 1)\}$, and indicates that the 1st column of the column group $S_6$, the 2nd column of the column group $S_6$, and the 1st column of the column group $S_7$ are reserved.

For example, the second set includes at most one column group. In other words, a manner of selecting the first column set based on the plurality of column groups is: reserving all columns in some of the plurality of column groups and some columns in at most one of the plurality of column groups. For example, all columns of some column groups of L3 are reserved. In other words, the second column group set is an empty set.

Optionally, in this embodiment of this application, some or all rows of the second base graph may include a plurality of row groups, the plurality of row groups and the plurality of column groups may form a plurality of grouping structures or grouping units, and a column weight of a column of a grouping unit included in the second base graph is not greater than 1. Specifically, the grouping units included in the second base graph may be classified into three types. A column weight of each column of a first-type grouping unit is 1, a column weight of at least one column of a second-type grouping unit is 1 and a column weight of a remaining column is 0, and a column weight of each column of a third-type grouping unit is 0. For specific descriptions, refer to the first possible implementation. In this case, in the third possible implementation, most grouping units in the second base graph may be reserved. This helps improve hardware resource utilization.

In the foregoing several implementations, the second base graph is a base graph of a largest scale stored in the transmit end device, and the transmit end device directly obtains, based on the second base graph, the first base graph required by the transmit end device.

In some other embodiments of this application, the second base graph may not be a base graph of a largest scale stored in the transmit end device, but may be a base graph derived from the base graph of the largest scale stored in the transmit end device. The transmit end device may first export the second base graph based on the stored base graph of the largest scale, and then derive the first base graph based on the second base graph. This deriving manner is referred to as a nested derivation manner below. The second base graph includes a second column set and all check columns of the base graph of the largest scale stored in the transmit end device, the second column set includes some information columns of the base graph of the largest scale stored in the transmit end device, and the second column set includes the first column set.

For example, the LDPC code provided in this embodiment of this application relates to three base graphs: the base graph of the largest scale, the second base graph, and the first base graph. It is assumed that the base graph of the largest scale stored in the transmit end device is a BG 1, the second base graph is a BG 2, and the first base graph is a BG 3. The BG 2 and the BG 3 may be derived from the BG 1. The BG 3 may be directly derived from the BG 1 or may be derived in a nested derivation manner. In other words, the BG 2 is derived from the BG 1, and then the BG 3 is derived from the BG 2.

It is assumed that $L_1$ represents a set of punctured information columns of a base graph, $L_2$ represents a set of core check columns of the base graph, $L_3$ represents a set of non-punctured information columns of the base graph, and $L_4$ represents a set of extended check columns of the base graph. If the base graph does not include a punctured information column, $L_1$ is an empty set. If the base graph does not include an extended check column, $L_4$ is an empty set.

For example, column grouping of the BG 1 is that three adjacent columns are grouped into one group. The BG 2 includes all columns of $L_1$ of the BG 1, all columns of $L_2$ of the BG 1, a 1st column and a 2nd column of each of the plurality of column groups of $L_3$ of the BG 1, and all columns of $L_4$ of the BG 1. The BG 3 includes all columns of $L_1$ of the BG 1, all columns of $L_2$, the 1st column of each of the plurality of column groups of $L_3$, and all columns of $L_4$. Therefore, the BG 3 may be derived by directly obtaining all columns of $L_1$ of the BG 1, all columns of $L_2$ of the BG 1, the 1st column of each of the plurality of column groups of $L_3$ of the BG 1, and all columns of $L_4$ of the BG 1. Alternatively, the BG 3 may be derived by first obtaining all columns of $L_1$ of the BG 1, all columns of $L_2$ of the BG 1, the 1st column and the 2nd column of each of the plurality of column groups of $L_3$ of the BG 1, and all columns of $L_4$ of the BG 1 to obtain the BG 2, and then obtaining all columns of $L_1$ of the BG 2, all columns of $L_2$ of the BG 2, the 1st column of each of the plurality of column groups of $L_3$ of the BG 2, and all columns of $L_4$ of the BG 2 to obtain the BG 3. In this case, as described in the standard protocol, a manner of deriving the BG 2 from the BG 1 is selecting the 1st column and the 2nd column of each of the plurality of column groups of $L_3$ of the BG 1, and a manner of deriving the BG 3 from the BG 2 is selecting the 1st column of each of the plurality of column groups of $L_3$ of the BG 2, or a manner of deriving the BG 2 from the BG 1 is selecting the 1st column and the 2nd column of each of the plurality of column groups of $L_3$ of the BG 1, and a manner of deriving the BG 3 from the BG 1 is selecting the 1st column of each of the plurality of column groups of $L_3$ of the BG 1.

For example, the BG 1 includes two punctured information columns, four core check columns, and 30 non-punctured information columns, and the non-punctured information columns of the BG 1 are grouped by using three adjacent columns as a group; the BG 2 includes two punctured information columns of the BG 1, four core check columns of the BG 1, and two columns of each column group included in the non-punctured information columns of the BG 1, and the non-punctured information columns of the BG 2 are grouped by using two adjacent columns as a group; and the BG 3 includes two punctured information columns of the BG 2, four core check columns of the BG 2, and one column of each column group included in the non-punctured information columns of the BG 2. In this case, the BG 3 may be derived by directly obtaining the two punctured information columns of the BG 1, the four core check columns of the BG 1, and one column of each column group included in the non-punctured information columns of the BG 1. Alternatively, the BG 3 may be derived by first obtaining the two punctured information columns of the BG 1, the four core check columns of the BG 1, and the two columns of each column group included in the non-punctured information columns of the BG 1 to obtain the BG 2, and then obtaining two punctured information columns of the BG 2, four core check columns of the BG 2, and one column of each column group included in the non-punctured information columns of the BG 2 to obtain the BG 3. This is not limited.

For a case in which more base graphs are involved, a nested derivation manner may be obtained by analogy based on nested derivation involving three base graphs.

For example, the BG 1 includes two punctured information columns, four core check columns, and 40 non-punctured information columns, and the non-punctured information columns of the BG 1 are grouped by using four adjacent columns as a group; the BG 2 includes two punctured information columns of the BG 1, four core check columns of the BG 1, and three columns of each column group included in the non-punctured information columns of the BG 1, and the non-punctured information columns of the BG 2 are grouped by using three adjacent columns as a group; the BG 3 includes two punctured information columns of the BG 2, four core check columns of the BG 2, and two columns in each column group included in the non-punctured information columns of the BG 2; and the BG 4 includes two punctured information columns of the BG 3, four core check columns of the BG 2, and one column in each of column groups included in the non-punctured information columns of the BG 2. In this case, the BG 4 may be derived by directly obtaining the two punctured information columns of the BG 1, the four core check columns of the BG 1, and one column of each column group included in the non-punctured information columns of the BG 1. Alternatively, the BG 4 may be derived by first obtaining the two punctured information columns of the BG 1, the four core check columns of the BG 1, and the three columns of each column group included in the non-punctured information columns of the BG 1 to obtain the BG 2, and then obtaining the two punctured information columns of the BG 2, the four core check columns of the BG 2, and one column in each column group included in the non-punctured information columns of the BG 2 to obtain the BG 4. Alternatively, the BG 4 may be derived by first obtaining the two punctured information columns of the BG 1, the four core check columns of the BG 1, and the three columns in each column group included in the non-punctured information columns of the BG 1 to obtain the BG 2, then obtaining the two punctured information columns of the BG 2, the four core check columns of the BG 2, and two columns in each column group included in the non-punctured information columns of the BG 2 to obtain the BG 3, and then obtaining the two punctured information columns of the BG 3, the four core check columns of the BG 3, and one column in each column group included in the non-punctured information columns of the BG 3 to obtain the BG 4. This is not limited.

In this way, if a $BG_X$ is derived in the nested derivation manner, all connection edge relationships of a BG 1, offset values of non-zero elements of the BG 1, and a manner of selecting columns from $L_3$ of the BG 1, $L_3$ of a BG 2, ..., and $L_3$ of a BG x-1 are defined in the standard protocol, and connection edge relationships of the BG 2, a BG 3, ..., and the BG x, and offset values of non-zero elements of the BG 2, the BG 3, ..., and the BG x do not need to be described. The description is very concise. Correspondingly, the transmit end device stores all the connection edge relationships of the BG 1, the offset values of the non-zero elements of the BG 1, and the manner of selecting columns from $L_3$ of the BG 1, $L_3$ of the BG 2, ..., and $L_3$ of the BG x-1, and does not need to store the connection edge relationships of the BG 2, the BG 3, ..., and the BG x, and the offset values of the non-zero elements of the BG 2, the BG 3, ..., and the BG x. Therefore, stored content is greatly reduced.

When the nested derivation manner is used, for a manner in which the transmit end device derives the second base graph from the stored base graph of the largest scale and a manner in which the transmit end device derives the first base graph from the second base graph, refer to the foregoing manner in which the first base graph is derived from the second base graph. A difference lies in that a specific location, a first sequence, first information, and second information involved in a derivation process are different. For example, when the second base graph is derived from the stored base graph of the largest scale, a derivation principle indicates a specific location of each column group that needs to be reserved for obtaining the second base graph. The first sequence indicates columns that are used to form the second column set and that are in each of a plurality of column groups of the base graph of the largest scale. The first information and the second information correspond to the second base graph. The first information indicates a column group that is required for obtaining the second base graph and in which all columns are reserved. The second information indicates a column group that is required for obtaining the second base graph and in which some columns are reserved, and columns in the corresponding column group.

In some embodiments of this application, a nested derivation manner of the base graph may be represented by a storage sequence. The storage sequence has a clear segment structure. One element in the storage sequence may correspond to one column. For example, the storage sequence is a sequence including a column number. Different base graphs may be obtained based on sequences of different lengths that are captured from the storage sequence. For example, a first base graph may be obtained based on a first sequence whose length is P that is obtained by capturing first P elements from the storage sequence. A quantity of columns selected based on a plurality of column groups in a first column set of the first base graph is P, and one element of the first sequence may correspond to one of P columns selected based on the plurality of column groups.

It should be noted that when the storage sequence includes column numbers, the column numbers in the storage sequence may be column numbers obtained by numbering all information columns of a base graph of a largest scale stored in the transmit end device, or may be column numbers obtained by numbering all non-punctured information columns of a base graph of a largest scale stored in the transmit end device. This is not limited. For example, when the first column set includes columns selected based on a plurality of column groups and punctured information columns, the column numbers in the storage sequence may be column numbers obtained by numbering all information columns of a base graph of a largest scale stored in the transmit end device, or may be column numbers obtained by numbering all non-punctured information columns of a base graph of a largest scale stored in the transmit end device. For another example, when the first column set includes columns selected based on a plurality of column groups, the column numbers in the storage sequence may be column numbers obtained by numbering all information columns of a base graph of a largest scale stored in the transmit end device.

For example, it is assumed that $L_1$ represents a set of punctured information columns of a base graph, $L_2$ represents a set of core check columns of the base graph, $L_3$ represents a set of non-punctured information columns of the base graph, and $L_4$ represents a set of extended check columns of the base graph. If the base graph does not include a punctured information column, $L_1$ is an empty set. If the base graph does not include an extended check column, $L_4$ is an empty set. A storage sequence $\theta$ may be an arrangement of column numbers of columns in $L_3$ of a base graph of a largest scale stored in the transmit end device. If the transmit end device needs to use a base graph of $|L_1| + P$ information columns, the transmit end device may extract first P elements $\{\theta(1), \theta(2), ..., \theta(P)\}$ of the storage sequence $\theta$, and an information column set included in the base graph is $L_1 \cup \{\theta(1), \theta(2), ..., \theta(P)\}$.

For example, the base graph of the largest scale stored in the transmit end device is a BG 1, a second base graph is a BG 2, and a first base graph is a BG 3. It is assumed that a plurality of column groups of $L_3$ of the BG 1 are obtained by grouping three adjacent columns of the $L_3$ into one group. A manner of deriving the BG 2 from the BG 1 is selecting a 1st column and a 2nd column of each of the plurality of column groups of $L_3$ of the BG 1. A manner of deriving the BG 3 from the BG 2 is selecting a 1st column of each of the plurality of column groups of $L_3$ of the BG 2. In this case, the storage sequence $\theta$ may be {1, 4, 7, 10, 13, 16, 19, 22, 25, 28, 31, 2, 5, 8, 11, 14, 17, 20, 23, 26, 29, 32, 3, 6, 9, 12, 15, 18, 21, 24, 27, 30, 33}, and every 11 elements in the storage sequence $\theta$ may be divided into one segment. All segments of the storage sequence $\theta$ correspond to $L_3$ of the BG 1; first two segments of the storage sequence $\theta$, that is, first 22 elements {1, 4, 7, 10, 13, 16, 19, 22, 25, 28, 31, 2, 5, 8, 11, 14, 17, 20, 23, 26, 29, 32}, correspond to $L_3$ of the BG 2; and a first segment of the storage sequence $\theta$, that is, first 11 elements {1, 4, 7, 10, 13, 16, 19, 22, 25, 28, 31}, correspond to $L_3$ of the BG 3.

An advantage of obtaining the first column set based on the foregoing storage sequence is that base graphs of different dominant intervals can be filtered more precisely, and more applicable base graphs can be derived.

In this embodiment of this application, the first base graph may be in a form of a table, and the table corresponding to the first base graph may include two cases. Details are as follows:

Case 1: Column numbers of columns in the table corresponding to the first base graph are consecutive.

In Case 1, in a process of obtaining the first base graph, the connection edge relationship and the offset values of the elements in the first base graph need to be generated based on the connection edge relationship and the offset values of the elements in the second base graph.

For example, the plurality of column groups include non-punctured information columns of the second base graph, and the first column set includes columns selected based on the plurality of column groups and punctured information columns of the second base graph. A correspondence between connection edge relationships and offset values of elements in the first base graph and connection edge relationships and offset values of elements in the second base graph is as follows:

It is assumed that $L_1$ represents a set of punctured information columns of a base graph, and $L_3$ represents a set of non-punctured information columns of the base graph. Column grouping is performed on $L_3$ of the second base graph, to obtain t column groups, $L_3 = L'_1 \cup ... \cup L't$, and $L'_i \cap L'_j = \emptyset$. It is assumed that a manner of deriving $L_3$ of the first base graph from the second base graph is selecting $f_{L'_i}$ column sets of a group $L'_i$, and $f_{L'_i}(c)$ represents a $c^{th}$ selected column. In this case, a connection edge relationship included in a row of the first base graph includes the following three cases:

(1) when $j \in L_1$, $E_2(i,j) = E_1(i,j)$;
(2) when $|L_1| \leq j \leq |L_1| + \sum_{1 \leq w \leq t}|f(L'_w)|$, $E_2(i,j) = E_1(i, f_{C_k}(j - |L_1| - \sum_{1 \leq w \leq k}|f(L_w)|))$, where $k = \arg\max_x |L_1| + \sum_{1 \leq w \leq x}|f(L'_w)|) \leq j$; or

(3) when $j \geq |L_1| + \sum_{1 \leq w \leq t}|f(L_w)|$, $E_2(i,j) = E_1(i, j + \sum_{1 \leq w \leq t}|L_w| - |f(L_w)|))$.

Herein, j represents a jth row of the first base graph, $E_1(i, j)$ represents a connection edge relationship between an ith row and a jth column of the second base graph (including two cases: a connection edge relationship exists and a connection edge relationship does not exist), $E_2(i, j)$ represents a connection edge relationship between an ith row and a jth column of the first base graph, and $|\cdot|$ represents a quantity of elements in the set.

The offset value of the first base graph is consistent with the connection edge relationship included in the row of the first base graph, and there are also three cases, which are specifically as follows:

(1) when $j \in L_1$, $S_2(i,j) = S_1(i,j)$;

(2) when $|L_1| \leq j \leq |L_1| + \sum_{1 \leq w \leq t}|f(L'_w)|$, $S_2(i,j) = S_1(i, f_{C_k}(j - |L_1| - \sum_{1 \leq w \leq k}|f(L_w)|))$, where $k = \arg\max_x |L_1| + \sum_{1 \leq w \leq x}|(L'_w)|) \leq j$; or

(3) when $j \geq |L_1| + \sum_{1 \leq w \leq t}|f(L_w)|$, $S_2(i,j) = S_1(i, j + \sum_{1 \leq w \leq t}|L_w| - |f(L_w)|))$.

Herein, j represents a jth row of the first base graph, $S_1(i, j)$ represents an offset value of an element in an ith row and a jth column of the second base graph, $S_2(i, j)$ represents an offset value of an ith row and a jth column of the first base graph, and $|\cdot|$ represents a quantity of elements in the set.

In Case 1, because the column number, the offset value, and the like are correspondingly modified in a process of obtaining the first base graph, encoding and rate matching may be directly performed based on the first base graph, and no additional operation is required.

Case 2: A number of each column in the table corresponding to the first base graph is the same as a number of each column in the table corresponding to the second base graph.

In Case 2, a column that is not included in the first base graph may be directly deleted from the table corresponding to the second base graph. Because only an unused column is deleted, in comparison with the second base graph, a column number and a connection edge relationship of a column reserved in the first base graph do not change. In this case, a process of performing encoding based on the first base graph needs to be changed, and the change is mainly reflected in a shortened bit (shorten bit).

Given that a target information length is K', a lifting size is $Z_c$, and an unused column set is set to $L'_1, L'_2, ..., L'_t$, there is an indication sequence $\delta$, and $\delta(j) = <Null>$, where $j \in [(L'_i - 1)Z_c + 1, L'_i Z_c]$, j is an integer, and $1 \leq i \leq t$. If $\delta(i) \neq <Null>$, a to-be-encoded bit sequence $\gamma$ is equal to an information bit; or if $\delta(i) = <Null>$, $\gamma = 0$. Then, the to-be-encoded bit sequence $\gamma$ is encoded.

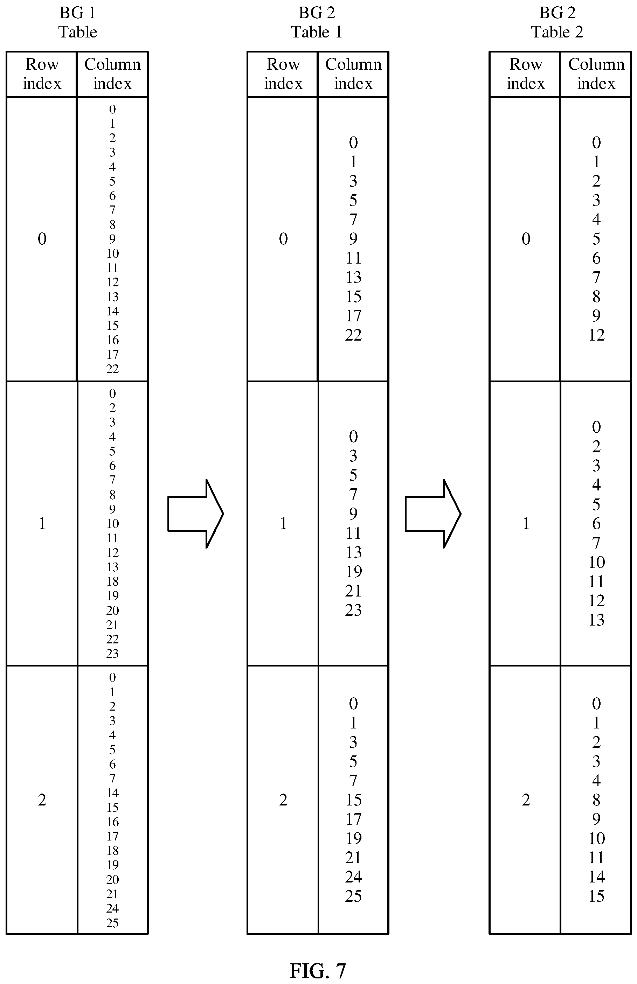

FIG. 7 shows an example of two cases of a table corresponding to a first base graph. In FIG. 7, for example, the second base graph is a BG 1 and the first base graph is a BG 2. A table 1 of the BG 2 in FIG. 7 corresponds to Case 2, and a table 2 of the BG 2 corresponds to Case 1.

In some embodiments of this application, before step 602, the transmit end device may further determine to perform LDPC encoding on the information bit sequence based on the first base graph. A specific implementation in which the transmit end device determines to perform LDPC encoding on the information bit sequence based on the first base graph is not limited in this embodiment of this application.

In a possible implementation, the transmit end device determines, based on screening information, to perform LDPC encoding on the information bit sequence based on the first base graph. The screening information includes at least one of the following information: an application scenario corresponding to the information bit sequence, a code rate (referred to as a target code rate below) required for transmitting the information bit sequence, a code length (referred to as a target code length below) required for transmitting the information bit sequence, or a quantity of non-zero elements included in the first base graph. The application scenario may include at least one of the following scenarios: a high-throughput scenario, a high-reliability scenario, a low-latency scenario, a high-reliability and low-latency scenario, or a low power consumption scenario. The high-throughput scenario may be, for example, an enhanced mobile broadband (Enhanced Mobile Broadband, eMBB) scenario. The high-reliability and low-latency scenario may be, for example, a URLLC (Ultra Reliable Low Latency Communication) scenario. The low power consumption scenario may be, for example, an M2M scenario, an MTC scenario, or an IoT scenario. Optionally, the screening information may further include capability information of the terminal device, performance information of the terminal device, and/or the like.

When the screening information includes at least one of the code length required for transmitting the information bit sequence, the code rate required for transmitting the information bit sequence, or the quantity of non-zero elements included in the first base graph, and the application scenario corresponding to the information bit sequence, that the transmit end device determines, based on the screening information, to perform LDPC encoding on the information bit sequence based on the first base graph may include: When the application scenario corresponding to the information bit sequence is a predefined scenario, the transmit end device determines to perform LDPC encoding on the information bit sequence based on a first base graph that has a correspondence with the application scenario corresponding to the information bit sequence; and/or when the application scenario corresponding to the information bit sequence is not a predefined scenario, the transmit end device may further perform screening based on at least one of the target code length, the target code rate, or the quantity of non-zero elements included in the first base graph, to determine to perform LDPC encoding on the information bit sequence based on the first base graph.

In an example, a principle of performing screening by the transmit end device based on the screening information may be: determining whether the application scenario corresponding to the information bit sequence is an application scenario specified in a standard protocol. If the application scenario corresponding to the information bit sequence is an application scenario specified in the standard protocol, the base graph is selected according to a screening principle of the application scenario. A screening principle of each application scenario is described below. If the application scenario corresponding to the information bit sequence is not an application scenario specified in the standard protocol, screening is preferentially performed based on the target code rate and a code rate range supported by each base graph. If only one base graph supports the target code rate, the base graph is selected as the first base graph; or if a plurality of base graphs support the target code rate, screening is further performed based on the target code length and code length ranges supported by the plurality of base graphs that support the target code rate. If only one base graph supports the target code length, the base graph is selected as the first base graph; or if a plurality of base graphs support the target code length, screening is further performed based on a quantity of non-zero elements in the plurality of base graphs that support the target code length. For example, from the plurality of base graphs that support the target code length, a base graph that has a smallest quantity of non-zero elements is selected as the first base graph.

When the screening information includes the target code length, the target code rate, or the quantity of non-zero elements included in the first base graph, a principle of performing screening by the transmit end device based on the screening information may be: preferentially performing screening based on the target code rate and a code rate range supported by each base graph. If only one base graph supports the target code rate, the base graph is selected as the first base graph; or if a plurality of base graphs support the target code rate, screening is further performed based on the target code length and code length ranges supported by the plurality of base graphs that support the target code rate. If only one base graph supports the target code length, the base graph is selected as the first base graph; or if a plurality of base graphs support the target code length, screening is further performed based on a quantity of non-zero elements in the plurality of base graphs that support the target code length. For example, from the plurality of base graphs that support the target code length, a base graph that has a smallest quantity of non-zero elements is selected as the first base graph.

In this embodiment of this application, there are many manners of determining the application scenario corresponding to the information bit sequence. This is not limited.

Manner 1: The transmit end device may determine, based on control signaling between the transmit end device and the receive end device, an application scenario corresponding to the information bit sequence, to determine whether the application scenario corresponding to the information bit sequence is an application scenario defined in the standard protocol.

Manner 2: The transmit end device may determine, based on a modulation and coding scheme (Modulation and Coding Scheme, MCS) table, an application scenario corresponding to the information bit sequence, to determine whether the application scenario corresponding to the information bit sequence is an application scenario defined in the standard protocol.

In this embodiment of this application, application scenarios may be distinguished based on indicators such as a code length and a code rate, or a corresponding scenario type may be directly specified in the standard protocol. This is not limited.

The following describes screening principles in several application scenarios.

(1) High-throughput scenario

In the high-throughput scenario, an extremely high code rate and a medium code length (about 1 k to 2 k) are required.

For the high-throughput scenario, there are many implementations of a base graph selection principle. This is not limited.

In a possible implementation, when the target code rate is greater than a first threshold, a base graph of a largest scale stored in the transmit end device is selected as the first base graph. Optionally, the first threshold may be 0.926, 0.917, 5/6, or the like.

In another possible implementation, when a plurality of base graphs support the target code rate, screening may be further performed based on the target code length and code length ranges supported by the plurality of base graphs that support the target code rate. If only one base graph supports the target code length, the base graph is selected as the first base graph; or if a plurality of base graphs support the target code length, screening is further performed based on a quantity of non-zero elements in the plurality of base graphs that support the target code length. For example, from the plurality of base graphs that support the target code length, a base graph that has a smallest quantity of non-zero elements is selected as the first base graph.

It should be noted that, in some implementations, for a high-throughput scenario, an information bit corresponding to a punctured information column of the base graph also needs to be sent.

(2) High-reliability and low-latency scenario

Generally, in the high-reliability and low-latency scenario, an extremely low code rate and a medium or short code length (approximately within 2 k) are required.

For the high-reliability and low-latency scenario, there are many implementations of a base graph selection principle. This is not limited.

In a possible implementation, when the target code rate is less than a second threshold, another base graph is selected as the first base graph, and a base graph of a largest scale stored in the transmit end device is not selected as the first base graph. The another base graph may be derived from the base graph of the largest scale stored in the transmit end device. Optionally, the second threshold may be 1/3, 2/5, 1/5, 1/6, or the like.

In another possible implementation, a plurality of code rate thresholds may be set, and different code rate intervals correspond to different base graphs. When the target code rate falls within a code rate interval, a base graph corresponding to the code rate interval is selected as the first base graph.

It should be noted that, in some implementations, for the URLLC scenario, an information bit corresponding to a punctured column of the base graph also needs to be sent.

(3) Low power consumption scenario

In the low power consumption scenario, a base graph of a small scale, a small lifting size, and a small quantity of non-zero elements in the base graph are required. For the low power consumption scenario, there are many implementations of a base graph selection principle. This is not limited. In a possible implementation, screening may be preferentially performed based on a quantity of non-zero elements in the base graph. For example, a base graph with a smallest quantity of non-zero elements is selected as the first base graph.

It should be noted that the foregoing application scenarios and the corresponding screening principles are merely examples. There may be more application scenarios in the future. Correspondingly, screening principles may also be defined for these application scenarios.

In this embodiment of this application, the first base graph determined by the transmit end device includes two cases. In one case, the first base graph is a base graph of a largest scale stored in the transmit end device. In the other case, the first base graph is a base graph that can be derived from a base graph of a largest scale. For different cases, the transmit end device obtains the first base graph in different manners.

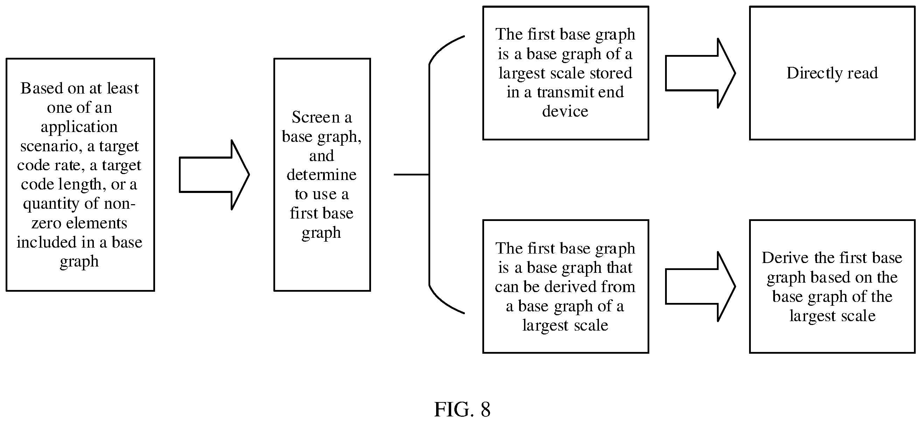

FIG. 8 is a diagram of a coding chain according to an embodiment of this application.

As shown in FIG. 8, a transmit end device may perform base graph screening based on at least one of an application scenario, a target code rate, a target code length, or a quantity of non-zero elements included in a base graph, to determine to use a first base graph. For different cases of the first base graph, the coding chain is divided into two branches. One branch corresponds to a case in which the first base graph is a base graph of a largest scale stored in the transmit end device. In this branch, the transmit end device may directly read a base graph of a largest scale as the first base graph. The other branch corresponds to a case in which the first base graph is a base graph that can be derived from a base graph of a largest scale. In this branch, the transmit end device needs to derive the first base graph based on the base graph of the largest scale. A specific derivation manner may be described above.

Step 603: The transmit end device sends an LDPC codeword sequence to the receive end device, or the receive end device receives the LDPC codeword sequence from the transmit end device.

It should be noted that, because a channel noise signal may be introduced in a transmission process of the LDPC codeword sequence, the LDPC codeword sequence output or sent by the transmit end device may be different from the LDPC codeword sequence received by the receive end device.

Step 604: The receive end device decodes the LDPC codeword sequence based on the first base graph.

The first base graph on which decoding of the receive end device is based is the same as the first base graph on which encoding of the receive end device is based. A manner in which the receive end device derives the first base graph based on the second base graph, a manner of determining to decode the LDPC codeword sequence based on the first base graph, and the like are the same as implementations of the transmit end device. For related descriptions, refer to the descriptions on the receive end device side. Details are not described herein again.

In addition, for the two cases of the table corresponding to the first base graph, operations of the receive end device are as follows: In Case 1, the receive end device may directly decode the LDPC codeword sequence based on the first base graph. In Case 2, the receive end device may perform filling processing on an information column that is not included in the first base graph and that belongs to the second base graph.

The following describes the information length, the code length, and the code rate of the base graph based on this embodiment of this application by using an example in which the second base graph is a BG 1, the first base graph is a BG x, and the non-punctured information columns in the second base graph are grouped.

It is assumed that a quantity of punctured columns in the BG 1 is $N_1$, a quantity of non-punctured information columns is $N_2$, a quantity of core check columns is $N_3$, a quantity of extended check columns is $N_4$, and a quantity of rows in the BG 1 is $N_3+N_4$. In this way, an information length range, a code length range, and a code rate range of the BG 1 are respectively as follows:

information length range: $[(N_1+N_2)Z_{c-min}, (N_1+N_2)Z_{c-max}]$;
code length range: $[(N_1+N_2+N_3)Z_{c-min}, (N_1+N_2+N_3+N_4)Z_{c-max}]$; and

code rate range: $\left[\dfrac{N_1+N_2}{N_2+N_3+N_4}, \dfrac{N_1+N_2}{N_2+N_3}\right]$.

The non-punctured information columns of the BG 1 are grouped, and t subsets obtained through column grouping are $L'_1 \cup ... \cup L'_t$. If a manner of generating the BG x is selecting $f_{L'_i}$ column sets of a column group $L'_i$, a quantity of non-punctured information columns of the BG x is $\sum_{1\leq w\leq t}|f(L'_w)|$, and an information length range, a code length range, and a code rate range of the BG x are respectively as follows:

information length range: $[(N_1 + \sum_{1\leq w\leq t}|f(C'_w)|)Z_{c_{min}}, (N_1 + \sum_{1\leq w\leq t}|f(C'_w)|)Z_{c\_max}]$;
code length range: $[(N_1 + \sum_{1\leq w\leq t}|f(C'_w)| + N_3)Z_{c_{min}}, (N_1 + \sum_{1\leq w\leq t}|f(C'_w)| + N_3 + N_4)Z_{c\_max}]$; and

code rate range: $\left[\dfrac{N_1+\sum_{1\leq w\leq t}|f(C'_w)|}{\sum_{1\leq w\leq t}|f(C'_w)|+N_3+N_4}, \dfrac{N_1+\sum_{1\leq w\leq t}|f(C'_w)|}{\sum_{1\leq w\leq t}|f(C'_w)|+N_3}\right]$.

As x increases, a quantity of punctured columns, a quantity of core check columns, and a quantity of extended check columns included in the BG x remain unchanged, and a quantity of non-punctured information columns decreases. In this way, both a maximum code rate and a minimum code rate that are supported by the BG x are reduced, a maximum code length range supported by the BG x is also reduced, and the BG x and the BG 1 may have a common code length range and a common code rate range. The common code length range and the common code rate range may be determined by factors such as a throughput, a delay requirement, performance, and a CB-level CRC loss.

A specific example is as follows: A quantity of punctured columns of the BG 1 is 2, a quantity of information columns of non-punctured columns is 30, a quantity of core check columns is 4, and a quantity of extended check columns is 42. The information columns of the non-punctured columns of the BG 1 are grouped into one group every three columns, and there are 10 groups. Information columns of the BG 2 include a punctured column of the BG 1 and a 1st column and a 2nd column of each column group. Information columns of the BG 3 include a punctured column of the BG 1 and a 1st column of each column group. In this way, a code rate range of the BG 1 is [0.4211, 0.9412], and an information length range is $[32Z_{c-min}, 32Z_{c-max}]$. A code rate range of the BG 2 is [1/3, 0.9167], and an information length range is $[22Z_{c-min}, 22Z_{c-max}]$. A code rate range of the BG 3 is [0.8571, 0.2143], and an information length range is $[12Z_{c-min}, 12Z_{c-max}]$. It can be learned that, in comparison with the BG 1, both a highest code rate and a lowest code rate supported by the BG 2 and the BG 3 are reduced, and maximum information length ranges supported by the BG 2 and the BG 3 are also reduced. The BG 2, the BG 3, and the BG 1 have a common code rate range.

It should be noted that the plurality of base graphs in this application may be applied to different scenarios, or may be applied to a same scenario. This is not limited.

The following describes performance of an LDPC code in embodiments of this application with reference to a simulation result.

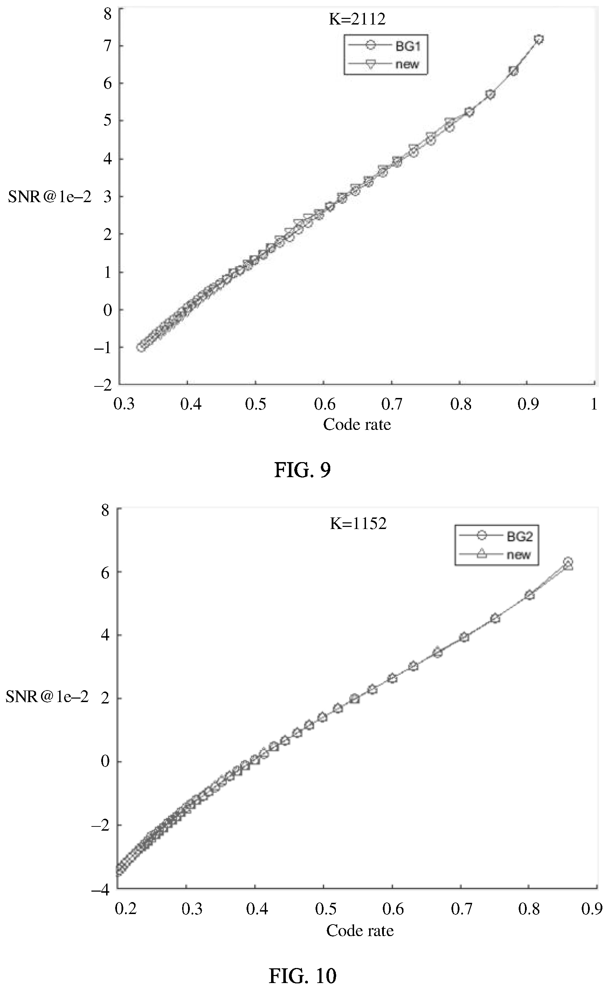

FIG. 9 shows simulation results 1 of signal-to-noise ratios of LDPC codes at different code rates.

The signal-to-noise ratio may reflect extreme decoding performance. FIG. 9 shows simulation results of signal-to-noise ratios of a NR LDPC code using the BG 1 and an LDPC code provided in this application at different code rates. As shown in FIG. 9, a signal-to-noise ratio of the NR LDPC code using the BG 1 at each code rate is basically the same as a signal-to-noise ratio of the LDPC code provided in this application at each code rate.

FIG. 10 shows simulation results 2 of SNRs of LDPC codes at different code rates.

FIG. 10 shows simulation results of signal-to-noise ratios of a NR LDPC code using the BG 2 and an LDPC code provided in this application at different code rates. As shown in FIG. 10, a signal-to-noise ratio of the NR LDPC code using the BG 2 at each code rate is basically the same as a signal-to-noise ratio of the LDPC code provided in this application at each code rate.

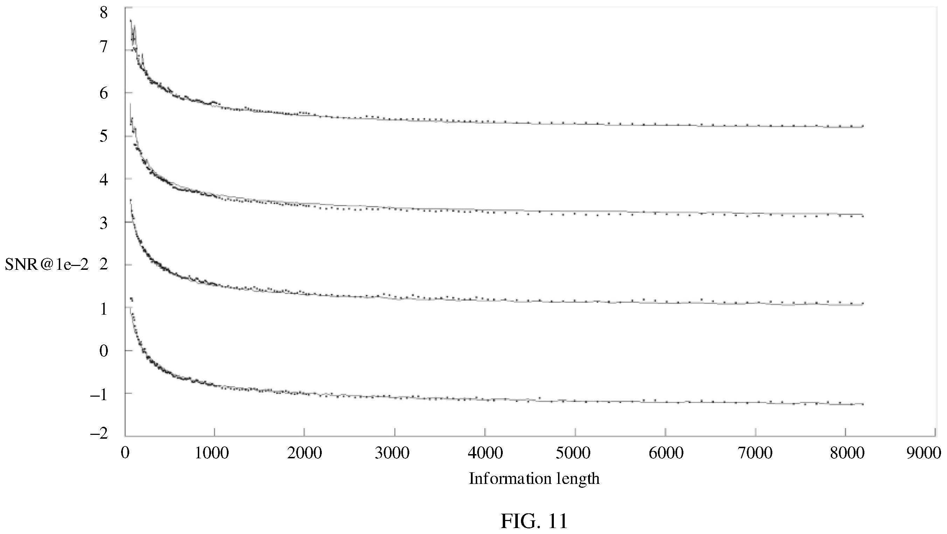

FIG. 11 shows simulation results 1 of signal-to-noise ratios of LDPC codes in different information lengths and at different code rates.

FIG. 11 shows simulation results of signal-to-noise ratios of a NR LDPC codes using the BG 1 and an LDPC code provided in this application in different information lengths (information length), at different code rates, and through 20 rounds of aligned decoding iterations. In FIG. 11, a solid line represents a simulation result of the NR LDPC code using the BG 1, and a dashed line represents a simulation result of the LDPC code provided in this application. Code rates corresponding to four curves sequentially decrease from top to bottom. As shown in FIG. 11, signal-to-noise ratios of the NR LDPC code using the BG 1 and the LDPC code provided in this application in various information lengths are basically the same. In other words, compared with the NR LDPC code using the BG 1, the LDPC code provided in this application does not lose decoding performance.

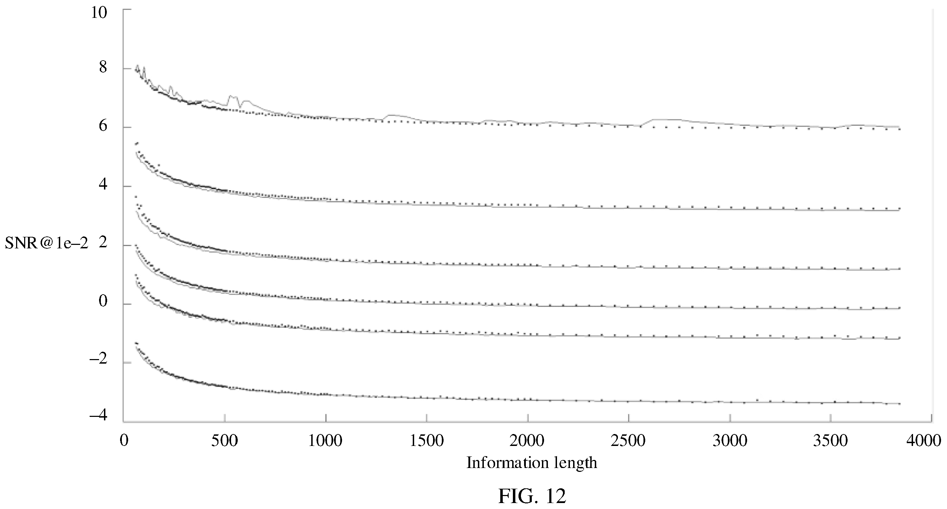

FIG. 12 shows simulation results 2 of signal-to-noise ratios of LDPC codes in different information lengths and at different code rates.

FIG. 12 shows simulation results of signal-to-noise ratios of a NR LDPC code using the BG 2 and an LDPC code provided in this application in different information lengths, at different code rates, and through 20 rounds of aligned decoding iterations. In FIG. 12, a solid line represents a simulation result of the NR LDPC code using the BG 2, and a dashed line represents a simulation result of the LDPC code provided in this application. Code rates corresponding to four curves sequentially decrease from top to bottom. As shown in FIG. 12, compared with the NR LDPC code using the BG 2, the LDPC code provided in this application does not lose decoding performance, and performance of the LDPC code provided in this application is more stable at a high code rate.

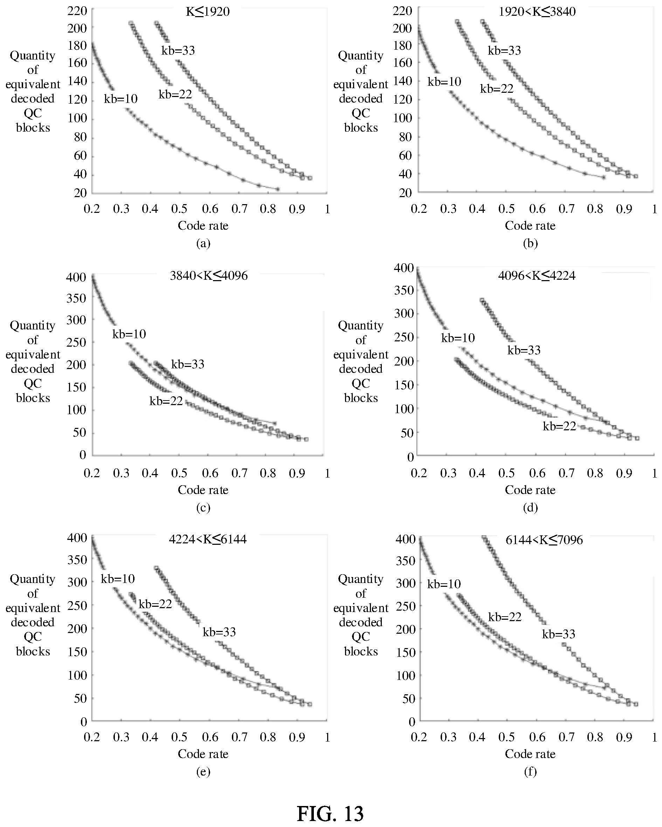

FIG. 13 shows simulation results of quantities of equivalent decoded QC blocks of different base graphs of an LDPC code according to this application.

A quantity of equivalent decoded QC blocks may reflect performance in aspects such as decoding complexity and a delay. FIG. 13 shows simulation results of quantities of equivalent decoded QC blocks of a BG 1, a BG 2, and a BG 3 of an LDPC code according to this application in different code lengths, and (a) in FIG. 13 to (f) in FIG. 13 respectively correspond to code length intervals such as $K \leq 1920$, $1920 < K \leq 3840$, $3840 < K \leq 4096$, $4096 < K \leq 4224$, $4224 < K \leq 6144$, and $6144 < K \leq 7096$. A quantity of information columns in the BG 1 is 33, a quantity of information columns in the BG 2 is 22, and a quantity of information columns in the BG 3 is 10. It can be learned from FIG. 13 that a dominant interval of the BG 2 is mainly in a short code and low rate region, and a dominant interval of the BG 3 is mainly in a long code and high rate region. In this way, based on dominant intervals of different base graphs, only the BG 1 is stored, and a required base graph is derived based on the BG 1. This helps obtain a base graph with a lower latency and lower complexity.

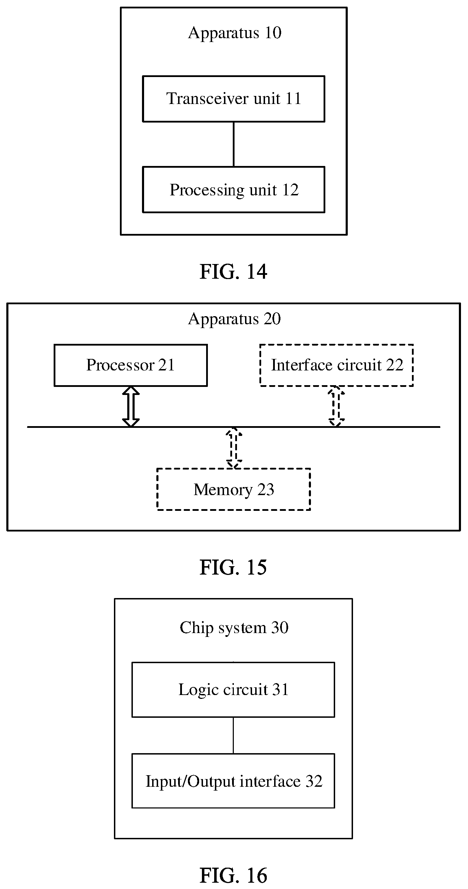

The foregoing describes in detail the method embodiments provided in this application with reference to FIG. 1 to FIG. 13. The following describes apparatus embodiments of this application with reference to FIG. 14 to FIG. 16.

It may be understood that, to implement functions in the foregoing embodiments, apparatuses in FIG. 14 to FIG. 16 each include a corresponding hardware structure and/or software module for performing each function. A person skilled in the art should be easily aware that, in this application, the units and method steps in the examples described with reference to embodiments disclosed in this application can be implemented by hardware or a combination of hardware and computer software.

FIG. 14 and FIG. 15 each are a diagram of a structure of a possible apparatus according to an embodiment of this application. These apparatuses may be configured to implement functions of the transmit end device or the receive end device in the foregoing method embodiments. Therefore, beneficial effect of the foregoing method embodiments can also be implemented.

As shown in FIG. 14, an apparatus 10 includes a transceiver unit 11 and a processing unit 12.

When the apparatus 10 is configured to implement functions of the transmit end device in FIG. 6, the transceiver unit 11 is configured to perform receiving and sending steps of the transmit end device, for example, step 603, and the processing unit 12 is configured to perform processing steps of the transmit end device, for example, step 601 and step 602. When the apparatus 10 is configured to implement functions of the receive end device in FIG. 6, the transceiver unit 11 is configured to perform receiving and sending steps of the receive end device, for example, step 603, and the processing unit 12 is configured to perform a processing step of the receive end device, for example, step 604.

For more detailed descriptions of the transceiver unit 11 and the processing unit 12, refer to related descriptions in the foregoing method embodiments. Details are not described herein.

As shown in FIG. 15, an apparatus 20 includes a processor 21. The processor 21 is coupled to a memory 23. The memory 23 is configured to store instructions. When the apparatus 20 is configured to implement the foregoing method, the processor 21 is configured to execute the instructions in the memory 23, to implement functions of the processing unit 12.

Optionally, the apparatus 20 further includes the memory 23.

Optionally, the apparatus 20 further includes an interface circuit 22. The processor 21 and the interface circuit 22 are coupled to each other. It may be understood that the interface circuit 22 may be a transceiver or an input/output interface. When the apparatus 20 is configured to implement the foregoing method, the processor 21 is configured to execute the instructions to implement the functions of the processing unit 12, and the interface circuit 22 is configured to implement functions of the transceiver unit 11.

For example, when the apparatus 20 is a chip used in the transmit end device or the receive end device, the chip implements functions of the transmit end device or the receive end device in the foregoing method embodiments. The chip receives information from another module (for example, a radio frequency module or an antenna) in the transmit end device or the receive end device, where the information is sent by another apparatus to the transmit end device or the receive end device; or the chip sends information to another module (for example, a radio frequency module or an antenna) in the transmit end device or the receive end device, where the information is sent by the transmit end device or the receive end device to another apparatus.

FIG. 16 is a diagram of a chip system 30 according to an embodiment of this application. The chip system 30 (or may be referred to as a processing system) includes a logic circuit 31 and an input/output interface (input/output interface) 32.

The logic circuit 31 may be a processing circuit in the chip system 30. The logic circuit 31 may be coupled to and connected to a storage unit, and invoke instructions in the storage unit, to enable the chip system 30 to implement the methods and functions in embodiments of this application. The input/output interface 32 may be an input/output circuit in the chip system 30, and outputs information processed by the chip system 30, or inputs to-be-processed data or signaling information into the chip system 30 for processing.

In a solution, the chip system 30 is configured to implement operations performed by the transmit end device or the receive end device in the foregoing method embodiments.

For example, the logic circuit 31 is configured to implement processing-related operations performed by the transmit end device or the receive end device in the foregoing method embodiments. The input/output interface 32 is configured to implement sending and/or receiving related operations performed by the transmit end device or the receive end device in the foregoing method embodiments.

This application further provides a communication apparatus, including a processor. The processor is coupled to a memory. The memory is configured to store a computer program or instructions and/or data. The processor is configured to execute the computer program or the instructions stored in the memory, or read the data stored in the memory, to perform the method in the foregoing method embodiments. Optionally, there are one or more processors. Optionally, the communication apparatus includes the memory. Optionally, there are one or more memories. Optionally, the memory and the processor are integrated together or disposed separately.

This application further provides a chip, including a processor, where the processor is coupled to a memory, the memory is configured to store a computer program or instructions, and the processor is configured to execute the computer program or the instructions stored in the memory, to implement the method performed by the transmit end device or the receive end device in the foregoing method embodiments.

This application further provides a computer-readable storage medium. The computer-readable storage medium stores computer instructions for implementing the method performed by the transmit end device or the receive end device in the foregoing method embodiments.

This application further provides a computer program product, including instructions. When the instructions are executed by a computer, the method performed by the transmit end device or the receive end device in the foregoing method embodiments is implemented.

This application further provides a communication system. The communication system includes at least one of the transmit end device or the receive end device in the foregoing embodiments.

For explanations and beneficial effects of related content in any one of the apparatuses provided above, refer to the corresponding method embodiment provided above. Details are not described herein again.

It can be understood that the processor in embodiments of this application may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a transistor logic device, a hardware component, or any combination thereof. The general purpose processor may be a microprocessor or any regular processor or the like.

The method steps in embodiments of this application may be implemented in a hardware manner, or may be implemented in a manner of executing software instructions by the processor. The software instructions may include a corresponding software module. The software module may be stored in a random access memory, a flash memory, a read-only memory, a programmable read-only memory, an erasable programmable read-only memory, an electrically erasable programmable read-only memory, a register, a hard disk drive, a removable hard disk drive, a compact disc read-only memory (compact disc read-only memory, CD-ROM), or any other form of storage medium well-known in the art. For example, a storage medium is coupled to a processor, so that the processor can read information from the storage medium and write information into the storage medium. Certainly, the storage medium may be a component of the processor. The processor and the storage medium may be disposed in an ASIC. In addition, the ASIC may be located in a transmit end device or a receive end device. Certainly, the processor and the storage medium may exist in the transmit end device or the receive end device as discrete components.

All or some of the foregoing embodiments may be implemented through software, hardware, firmware, or any combination thereof. When software is used to implement the foregoing embodiments, all or some of the foregoing embodiments may be implemented in a form of a computer program product. The computer program product includes one or more computer programs or instructions. When the computer programs or instructions are loaded and executed on a computer, the procedures or functions in embodiments of this application are all or partially executed. The computer may be a general-purpose computer, a special-purpose computer, a computer network, a network device, user equipment, or another programmable apparatus. The computer program or instructions may be stored in a computer-readable storage medium, or may be transmitted from a computer-readable storage medium to another computer-readable storage medium. For example, the computer program or instructions may be transmitted from a website, computer, server, or data center to another website, computer, server, or data center in a wired or wireless manner. The computer-readable storage medium may be any usable medium that can be accessed by the computer, or a data storage device, for example, a server or a data center, integrating one or more usable media. The usable medium may be a magnetic medium, for example, a floppy disk, a hard disk, or a magnetic tape; or may be an optical medium, for example, a digital video disc; or may be a semiconductor medium, for example, a solid-state drive.

In embodiments of this application, unless otherwise stated or there is a logic conflict, terms and/or descriptions in different embodiments are consistent and may be mutually referenced, and technical features in different embodiments may be combined based on an internal logical relationship thereof, to form a new embodiment.

Unless otherwise specified, meanings of all technical and scientific terms used in embodiments of this application are the same as those usually understood by a person skilled in the technical field of this application. The terms used in this application are merely intended to describe specific embodiments, and are not intended to limit the scope of this application. It should be understood that the foregoing descriptions are descriptions of examples, and the examples are merely intended to help a person skilled in the art understand embodiments of this application, but are not intended to limit embodiments of this application to specific values or specific scenarios in the examples. It is clear that a person skilled in the art can make various equivalent modifications or variations based on the examples described above, and such modifications and variations also fall within the scope of embodiments of this application.

## Claims

1. A low-density parity check LDPC code-based communication method, wherein the method comprises:

   obtaining an information bit sequence;
   encoding the information bit sequence based on a first base graph, to obtain an LDPC codeword sequence, wherein the first base graph comprises a first column set and check columns of a second base graph, the first column set is obtained based on at least one of a plurality of column groups comprised in information columns of the second base graph, column numbers comprised in any two of the plurality of column groups are different, and the second base graph comprises the check columns and the information columns; and
   outputting the LDPC codeword sequence.

2. The method according to claim 1, wherein the first column set comprises some information columns of the second base graph.

3. The method according to claim 1 or 2, wherein

   the plurality of column groups comprise the information columns of the second base graph, and the first column set comprises columns selected based on the plurality of column groups; or
   the plurality of column groups comprise non-punctured information columns of the second base graph, and the first column set comprises columns selected based on the plurality of column groups and a punctured information column of the second base graph.

4. The method according to claim 3, wherein

   a quantity of columns comprised in the plurality of column groups is 26, and a quantity of columns comprised in each of the plurality of column groups is 2; or
   a quantity of columns comprised in the plurality of column groups is 33 or 30, and a quantity of columns comprised in each of the plurality of column groups is 3; or
   a quantity of columns comprised in the plurality of column groups is 36 or 40, and a quantity of columns comprised in each of the plurality of column groups is 4.

5. The method according to claim 4, wherein a quantity of punctured information columns comprised in the second base graph is 0, 1, or 2.

6. The method according to any one of claims 1 to 5, wherein the method further comprises:

determining, based on screening information, to perform LDPC encoding on the information bit sequence based on the first base graph, wherein
the screening information comprises at least one of the following information: an application scenario of the information bit sequence, a code length required for transmitting the information bit sequence, a code rate required for transmitting the information bit sequence, or a quantity of non-zero elements comprised in the first base graph.

7. The method according to claim 6, wherein the application scenario comprises at least one of the following scenarios: a high-throughput scenario, a high-reliability scenario, a low-latency scenario, a high-reliability and low-latency scenario, or a low power consumption scenario.

8. The method according to any one of claims 1 to 7, wherein

the first column set comprises an $i^{th}$ column to a $j^{th}$ column of each of the plurality of column groups, and j-i is an integer greater than 0 and less than k; or
the first column set comprises an $m^{th}$ column of each of the plurality of column groups, and m is an integer less than k, wherein
k is a quantity of columns comprised in each of the plurality of column groups.

9. The method according to any one of claims 1 to 7, wherein
the first column set comprises all columns of each column group in a first set and some columns of each column group in a second set, and the first set and the second set do not overlap.

10. The method according to any one of claims 1 to 9, wherein the method further comprises:
determining the first base graph based on the second base graph and a first sequence, wherein the first sequence indicates columns that are in each of the plurality of column groups and that are used to form the first column set.

11. The method according to claim 10, wherein
a quantity of columns selected based on the plurality of column groups in the first column set is P, and the first sequence is obtained by extracting first P elements from a storage sequence.

12. The method according to any one of claims 1 to 11, wherein
when there is a punctured information column in the second base graph, the information columns in the second base graph comprise a punctured information column and non-punctured information columns.

13. A low-density parity check LDPC code-based communication method, wherein the method comprises:

receiving an LDPC codeword sequence; and
decoding the LDPC codeword sequence based on a first base graph, wherein the first base graph comprises a first column set and check columns of a second base graph, the first column set is obtained based on at least one of a plurality of column groups comprised in information columns of the second base graph, column numbers comprised in any two of the plurality of column groups are different, and the second base graph comprises the check columns and the information columns.

14. The method according to claim 13, wherein the first column set comprises some information columns of the second base graph.

15. The method according to claim 13 or 14, wherein

the plurality of column groups comprise the information columns of the second base graph, and the first column set comprises columns selected based on the plurality of column groups; or
the plurality of column groups comprise non-punctured information columns of the second base graph, and the first column set comprises columns selected based on the plurality of column groups and a punctured information column of the second base graph.

**16.** The method according to claim 15, wherein

a quantity of columns comprised in the plurality of column groups is 26, and a quantity of columns comprised in each of the plurality of column groups is 2; or
a quantity of columns comprised in the plurality of column groups is 33 or 30, and a quantity of columns comprised in each of the plurality of column groups is 3; or
a quantity of columns comprised in the plurality of column groups is 36 or 40, and a quantity of columns comprised in each of the plurality of column groups is 4.

**17.** The method according to claim 16, wherein a quantity of punctured information columns comprised in the second base graph is 0, 1, or 2.

**18.** The method according to any one of claims 13 to 17, wherein the method further comprises:

determining, based on screening information, to decode the LDPC codeword sequence based on the first base graph, wherein
the screening information comprises at least one of the following information: an application scenario of the information bit sequence, a code length required for transmitting the information bit sequence, a code rate required for transmitting the information bit sequence, or a quantity of non-zero elements comprised in the first base graph.

**19.** The method according to claim 18, wherein the application scenario comprises at least one of the following scenarios: a high-throughput scenario, a high-reliability scenario, a low-latency scenario, a high-reliability and low-latency scenario, or a low power consumption scenario.

**20.** The method according to any one of claims 13 to 19, wherein

the first column set comprises an $i^{th}$ column to a $j^{th}$ column of each of the plurality of column groups, and j-i is an integer greater than 0 and less than k; or
the first column set comprises an $m^{th}$ column of each of the plurality of column groups, and m is an integer less than k, wherein
k is a quantity of columns comprised in each of the plurality of column groups.

**21.** The method according to any one of claims 13 to 19, wherein
the first column set comprises all columns of each column group in a first set and some columns of each column group in a second set, and the first set and the second set do not overlap.

**22.** The method according to any one of claims 13 to 21, wherein the method further comprises:
determining the first base graph based on the second base graph and a first sequence, wherein the first sequence indicates columns that are in each of the plurality of column groups and that are used to form the first column set.

**23.** The method according to claim 22, wherein
a quantity of columns in the first column set is P, and the first sequence is obtained by extracting first P elements from a storage sequence.

**24.** The method according to any one of claims 13 to 23, wherein
when there is a punctured information column in the second base graph, the information columns in the second base graph comprise a punctured information column and non-punctured information columns.

**25.** A communication apparatus, comprising a module or a unit configured to perform the method according to any one of claims 1 to 24.

**26.** A communication apparatus, comprising a processor and an interface circuit, wherein the interface circuit is configured to: receive a signal from another communication apparatus other than the communication apparatus and transmit the signal to the processor, or send a signal from the processor to another communication apparatus other than the communication apparatus, and the processor is configured to implement the method according to any one of claims 1 to 24 through a logic circuit or by executing code instructions.

27. The communication apparatus according to claim 26, wherein the communication apparatus is a chip or a chip system.

28. A computer-readable storage medium, wherein the storage medium stores a computer program or instructions, and when the computer program or the instructions are executed by a communication apparatus, the method according to any one of claims 1 to 24 is implemented.

29. A computer program product, comprising a computer program, wherein when the computer program is run, the method according to any one of claims 1 to 24 is implemented.

30. A communication system, comprising:

a transmit end device, configured to perform the method according to any one of claims 1 to 12; and
a receive end device, configured to perform the method according to any one of claims 13 to 24.

FIG. 1

$$H = \begin{array}{cccccccc} V_1 & V_2 & V_3 & V_4 & V_5 & V_6 & V_7 & V_8 \end{array}$$

FIG. 2

FIG. 3

(a)

(b)

FIG. 4

FIG. 5

600

```
┌─────────────────┐                                    ┌─────────────────┐
│  Transmit end   │                                    │   Receive end   │
│     device      │                                    │     device      │
└─────────────────┘                                    └─────────────────┘
```

┌───────────────────────────┐
│      601: Obtain an        │
│  information bit sequence   │
└───────────────────────────┘

┌─────────────────────────────────────────────────┐
│ 602: Perform LDPC encoding on the information     │
│ bit sequence based on a first base graph, where the│
│ first base graph includes a column set and check  │
│ columns of a second base graph, the column set is │
│ obtained based on at least one of a plurality of  │
│ column groups included in information columns of   │
│ the second base graph, column numbers included in │
│ any two of the plurality of column groups are      │
│ different, and the second base graph includes the │
│ check columns and the information columns          │
└─────────────────────────────────────────────────┘

603: LDPC codeword sequence ──────────►

┌─────────────────────────────────────────────────┐
│ 604: Decode the LDPC codeword sequence based      │
│ on the first base graph, where the first base graph│
│ includes a column set and check columns of a       │
│ second base graph, the column set is obtained based│
│ on at least one of a plurality of column groups    │
│ included in information columns of the second base │
│ graph, column numbers included in any two of the   │
│ plurality of column groups are different, and the  │
│ second base graph includes the check columns and   │
│ the information columns                            │
└─────────────────────────────────────────────────┘

FIG. 6

BG 1
Table

| Row index | Column index |
|---|---|
| 0 | 0 1 2 3 4 5 6 7 8 9 10 11 12 13 14 15 16 17 22 |
| 1 | 0 2 3 4 5 6 7 8 9 10 11 12 13 18 19 20 21 22 23 |
| 2 | 0 1 2 3 4 5 6 7 14 15 16 17 18 19 20 21 24 25 |

BG 2
Table 1

| Row index | Column index |
|---|---|
| 0 | 0 1 3 5 7 9 11 13 15 17 22 |
| 1 | 0 3 5 7 9 11 13 19 21 23 |
| 2 | 0 1 3 5 7 15 17 19 21 24 25 |

BG 2
Table 2

| Row index | Column index |
|---|---|
| 0 | 0 1 2 3 4 5 6 7 8 9 12 |
| 1 | 0 2 3 4 5 6 7 10 11 12 13 |
| 2 | 0 1 2 3 4 8 9 10 11 14 15 |

FIG. 7

Based on at least one of an application scenario, a target code rate, a target code length, or a quantity of non-zero elements included in a base graph

→

Screen a base graph, and determine to use a first base graph

The first base graph is a base graph of a largest scale stored in a transmit end device

→

Directly read

The first base graph is a base graph that can be derived from a base graph of a largest scale

→

Derive the first base graph based on the base graph of the largest scale

FIG. 8

**FIG. 9**

**FIG. 10**

FIG. 11

FIG. 12

FIG. 13

Apparatus 10

Transceiver unit 11

Processing unit 12

FIG. 14

Apparatus 20

Processor 21

Interface circuit 22

Memory 23

FIG. 15

Chip system 30

Logic circuit 31

Input/Output interface 32

FIG. 16

## INTERNATIONAL SEARCH REPORT

| International application No. |
| --- |
| **PCT/CN2023/115376** |

| **A. CLASSIFICATION OF SUBJECT MATTER** |
| --- |
| H04L1/00(2006.01)i; H03M13/11(2006.01)i |
| According to International Patent Classification (IPC) or to both national classification and IPC |

| **B. FIELDS SEARCHED** |
| --- |
| Minimum documentation searched (classification system followed by classification symbols) |
| IPC:H04L,H03M |
| Documentation searched other than minimum documentation to the extent that such documents are included in the fields searched |
| Electronic data base consulted during the international search (name of data base and, where practicable, search terms used) |
| CNABS; CNTXT; ENTXT; ENTXTC; VEN; 3GPP: 基图, 投射图, 原模图, 原型图, 基矩阵, 校验列, 信息列, 打孔, LDPC, 码率, 非零元素, 分组; base graph, base matrix, check column, information column, punching, code rate, non-zero element |

| **C. DOCUMENTS CONSIDERED TO BE RELEVANT** | | |
| --- | --- | --- |
| Category* | Citation of document, with indication, where appropriate, of the relevant passages | Relevant to claim No. |
| A | CN 108988871 A (CHINA ACADEMY OF TELECOMMUNICATIONS TECHNOLOGY) 11 December 2018 (2018-12-11) entire document | 1-30 |
| A | CN 110870207 A (HUAWEI TECHNOLOGIES CO., LTD.) 06 March 2020 (2020-03-06) entire document | 1-30 |
| A | CN 108270510 A (HUAWEI TECHNOLOGIES CO., LTD.) 10 July 2018 (2018-07-10) entire document | 1-30 |
| A | US 2018337691 A1 (FUTUREWEI TECHNOLOGIES, INC.) 22 November 2018 (2018-11-22) entire document | 1-30 |
| A | ZTE, ZTE Microelectronics. "R1-1701600 "Further consideration on compact LDPC design for eMBB"" *3GPP tsg_ran\WG1_RL1*. No. TSGR1_88, 07 February 2017 (2017-02-07), entire document | 1-30 |

| ☐ Further documents are listed in the continuation of Box C. | ☑ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
| --- | --- |
| **29 November 2023** | **21 December 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/115376**

| Patent document cited in search report | | | Publication date (day/month/year) | Patent family member(s) | | | Publication date (day/month/year) |
|---|---|---|---|---|---|---|---|
| CN | 108988871 | A | 11 December 2018 | None | | | |
| CN | 110870207 | A | 06 March 2020 | US | 2020106458 | A1 | 02 April 2020 |
| | | | | US | 11115052 | B2 | 07 September 2021 |
| | | | | WO | 2018218692 | A1 | 06 December 2018 |
| | | | | EP | 3624350 | A1 | 18 March 2020 |
| | | | | EP | 3624350 | A4 | 17 June 2020 |
| CN | 108270510 | A | 10 July 2018 | None | | | |
| US | 2018337691 | A1 | 22 November 2018 | US | 10879927 | B2 | 29 December 2020 |
| | | | | WO | 2018210270 | A1 | 22 November 2018 |

Form PCT/ISA/210 (patent family annex) (July 2022)